(19) **Europäisches Patentamt**
**European Patent Office**
**Office européen des brevets**

(11) **EP 4 764 576 A1**

(12) # DEMANDE DE BREVET EUROPEEN

(43) Date de publication:
**24.06.2026 Bulletin 2026/26**

(21) Numéro de dépôt: **25219103.6**

(22) Date de dépôt: **27.11.2025**

(51) Classification Internationale des Brevets (IPC):
***G01R 33/028*** (2006.01)

(52) Classification Coopérative des Brevets (CPC):
**G01R 33/0286;** B06B 2201/54

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **03.12.2024 FR 2413365**

(71) Demandeur: **Commissariat à l'Energie Atomique et aux Energies Alternatives**
**75015 Paris (FR)**

(72) Inventeur: **NIKOLOVSKI, Jean-Pierre**
**38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(54) **DISPOSITIF DE DETECTION D'UN CHAMP MAGNETIQUE ET SYSTEME DE MESURE D'UN CHAMP MAGNETIQUE COMPRENANT UN TEL DISPOSITIF**

(57) La présente description concerne un système (10) de mesure d'un champ magnétique ($B_z$) comprenant un dispositif (20) de détection du champ magnétique comprenant un guide d'ondes acoustiques fuselé (40), un fil conducteur électriquement (50) rigidement couplé à une extrémité effilée du guide et un transducteur électroacoustique (60) rigidement couplé à la base du guide ; et un dispositif (30) de commande et d'acquisition relié au dispositif de détection du champ magnétique comprenant un générateur (331) fournissant une paire d'impulsions de courant de sens opposés ou une pluralité d'impulsions de courant modulées en fréquence dans le fil conducteur et un circuit d'acquisition (32) détectant des signaux électriques (S) fournis par le transducteur électroacoustique ou un générateur fournissant une paire impulsions de tension de signes opposés ou une pluralité d'impulsions de tension modulées en fréquence commandant le transducteur électroacoustique et un circuit d'acquisition détectant des signaux électriques fournis par le fil conducteur.

Fig 7

**Description**

Domaine technique

La présente description concerne de façon générale la mesure de champ magnétique statique ou variable dans le temps.

Technique antérieure

Pour certaines applications, il serait souhaitable de pouvoir mesurer un champ magnétique statique ou variable dans le temps avec une résolution spatiale inférieure à 0,2 mm. En outre, pour certaines applications, il serait souhaitable de pouvoir mesurer un champ magnétique variable dans le temps, notamment un champ magnétique impulsionnel ou à haute fréquence. De plus, pour certaines applications, il serait souhaitable de pouvoir mesurer avec un même dispositif un champ magnétique de faible intensité ou de forte intensité.

Le document US20240230795 décrit un dispositif de détection d'un champ magnétique comprenant un guide d'ondes acoustiques fuselé ayant une base et une première extrémité effilée, un fil conducteur électriquement rigidement couplé à l'extrémité effilée, et un transducteur électroacoustique rigidement couplé à la base. Un tel dispositif est adapté à la mesure de champ magnétique statique ou variable dans le temps avec une résolution spatiale inférieure à 0,2 mm.

Bien qu'un tel dispositif de détection soit tout à fait satisfaisant pour de nombreuses applications, il serait souhaitable qu'il puisse permettre la mesure de champs magnétiques faibles, notamment d'amplitude inférieure au champ magnétique terrestre, et d'atteindre une résolution inférieure au microtesla.

Résumé de l'invention

Un mode de réalisation pallie tout ou partie des inconvénients des dispositif connus de détection de champ magnétique et les systèmes de mesure de champ magnétique comprenant de tels dispositifs.

Un objet d'un mode de réalisation est que le dispositif de détection de champ magnétique permette la mesure d'un champ magnétique faible.

Un objet d'un mode de réalisation est que le dispositif de détection de champ magnétique ait une résolution inférieure au microtesla.

Un mode de réalisation prévoit un système de mesure d'un champ magnétique comprenant :

- un dispositif de détection du champ magnétique comprenant un guide d'ondes acoustiques fuselé ayant une base et une extrémité effilée, un fil conducteur électriquement rigidement couplé à l'extrémité effilée et un transducteur électroacoustique rigidement couplé à la base ; et
- un dispositif de commande et d'acquisition relié au dispositif de détection du champ magnétique comprenant un générateur configuré pour fournir une paire d'impulsions de courant de sens opposés ou une pluralité d'impulsions de courant modulées en fréquence dans le fil conducteur électriquement et un circuit d'acquisition configuré pour détecter des signaux électriques fournis par le transducteur électroacoustique ou un générateur configuré pour fournir une paire impulsions de tension de signes opposés ou une pluralité d'impulsions de tension modulées en fréquence commandant le transducteur électroacoustique et un circuit d'acquisition configuré pour détecter des signaux électriques fournis par le fil conducteur électriquement.

Selon un mode de réalisation, le générateur est configuré pour fournir une pluralité de paires d'impulsions de courant de sens opposés dans le fil conducteur électriquement ou une pluralité de paires d'impulsions de tension de signes opposés commandant le transducteur électroacoustique.

Selon un mode de réalisation, le générateur est configuré pour fournir les impulsions ayant des amplitudes maximales en valeur absolue identiques à mieux que 2 % prés.

Selon un mode de réalisation, la modulation de fréquence de la pluralité d'impulsions de courant ou de tension modulées en fréquence est située dans la bande passante du transducteur électroacoustique.

Selon un mode de réalisation, le circuit d'acquisition est configuré pour déterminer la différence entre les signaux électriques fournis pour la première impulsion de la paire d'impulsions et la deuxième impulsion de la paire d'impulsions.

Selon un mode de réalisation, le dispositif de commande et d'acquisition est configuré pour déterminer le temps de transit des ondes acoustiques dans le guide d'ondes acoustiques fuselé entre la base et l'extrémité effilée, le circuit d'acquisition étant configuré pour faire l'acquisition des signaux électriques dans une fenêtre temporelle dont le début par rapport à la première des impulsions dépend du temps de transit.

Selon un mode de réalisation, le fil conducteur électriquement comprend des première et deuxième extrémités, le transducteur électroacoustique comprend des premières et deuxièmes électrodes, et le générateur comprend des première et deuxième sources de tension. La première source de tension est reliée à la première extrémité du fil conducteur électriquement ou à la première électrode du transducteur électroacoustique.

Selon un mode de réalisation, la deuxième source de tension est reliée à la deuxième extrémité du fil conducteur électriquement ou à la deuxième électrode du transducteur électroacoustique.

Selon un mode de réalisation, le générateur comprend, en outre, un premier transformateur ayant un premier enroulement primaire relié à la première source et un premier enroulement secondaire relié à la première extrémité du fil conducteur électriquement ou à la première électrode du transducteur électroacoustique.

Selon un mode de réalisation, la deuxième source est reliée au premier enroulement primaire.

Selon un mode de réalisation, le générateur comprend, en outre, un deuxième transformateur ayant un deuxième enroulement primaire relié à la deuxième source et un deuxième enroulement secondaire relié à la première extrémité du fil conducteur électriquement ou à la première électrode du transducteur électroacoustique.

Selon un mode de réalisation, le générateur comprend, en outre, des résistances de valeurs différentes et un commutateur configuré pour mettre en série l'une des résistances avec la première extrémité du fil conducteur électriquement ou avec la première électrode du transducteur électroacoustique.

Selon un mode de réalisation, le générateur comprend, en outre, un tube à gaz de décharge entre la première source et la première extrémité du fil conducteur électriquement ou la première électrode du transducteur électroacoustique et un condensateur ayant une armature reliée à un noeud entre la première source et le tube à gaz de décharge.

Selon un mode de réalisation, le système comprend en outre un dispositif d'émission d'un rayonnement électromagnétique sur le tube à gaz de décharge.

Selon un mode de réalisation, le fil conducteur électriquement comprend une portion amincie rigidement couplée à l'extrémité effilée.

Selon un mode de réalisation, le guide d'ondes acoustiques fuselé comprend deux demi-guides d'ondes acoustiques fuselés en un matériau conducteur électriquement et comprenant chacun une extrémité pointue, les deux demi-guides d'ondes acoustiques fuselés étant distants l'un de l'autre sauf pour les deux pointes qui sont fusionnées.

Selon un mode de réalisation, le guide d'ondes acoustiques fuselé comprend en outre un bloc isolant électriquement entre les deux demi-guides d'ondes acoustiques fuselés et le transducteur électroacoustique.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe, partielle et schématique, d'un mode de réalisation d'un système de détection de champ magnétique comprenant une sonde et un dispositif de commande et d'acquisition ;

la figure 2, la figure 3, la figure 4, et la figure 5, sont des vues en coupe, partielles et schématiques, d'autres modes de réalisation de la sonde du système de détection ;

la figure 6 est une vue en perspective, partielle et schématique, de l'extrémité de la sonde de la figure 3 ;

la figure 7 et la figure 8 sont des schémas par blocs du système de détection de la figure 1 illustrant des modes de réalisation du dispositif de commande et d'acquisition du système de détection ;

la figure 9 représente des chronogrammes du signal de mesure fourni par un amplificateur du système de détection illustrant un effet thermoacoustique de la sonde ;

la figure 10 représente des chronogrammes du signal de mesure en l'absence de champ magnétique, et en présence de champs magnétiques de mêmes amplitudes et de sens opposés ;

la figure 11 représente un chronogramme d'une impulsion bipolaire de courant ;

la figure 12 est un chronogramme du signal de mesure fourni par le système de détection pour la mesure d'une onde acoustique réfléchie :

la figure 13 représente une courbe d'évolution de tension due à l'effet thermoacoustique et une courbe d'évolution de la sensibilité du système de détection en fonction de l'intensité d'impulsions de courant ;

la figure 14, la figure 15, la figure 16, et la figure 17 sont des schémas électriques de modes de réalisation d'un générateur d'impulsions de courant du système de détection de la figure 7 ;

la figure 18 est une vue en perspective, partielle et schématique, d'un mode de réalisation d'un fil conducteur de la sonde du système de détection ayant une portion amincie ;

la figure 19 est une vue en perspective, partielle et schématique, du fil conducteur à une étape intermédiaire d'un procédé de fabrication du fil conducteur ayant une portion amincie ;

la figure 20 et la figure 21 sont des vues en coupe, partielles et schématiques, de modes de réalisation de la sonde du système de détection ;

la figure 22 représente des chronogrammes du signal de mesure respectivement sans traitement et après la mise en oeuvre d'un procédé de compensation de l'effet thermoacoustique ;

la figure 23 représente un chronogramme de la réponse impulsionnelle d'un filtre adapté ;

la figure 24, la figure 25, et la figure 26 représentent des chronogrammes de signaux de mesure ;

la figure 27 est un chronogramme de signaux de commande de générateurs d'impulsions ;

la figure 28 est un schéma électrique d'un mode de réalisation d'un générateur d'impulsions de tension du système de détection de la figure 8 ;

la figure 29 représente un chronogramme d'un signal de mesure amplifié ;

la figure 30 représente une courbe de la transformée de Fourier du signal de mesure amplifié de la figure 29 ; et

la figure 31 et la figure 32 sont des schémas électriques d'autres modes de réalisation du générateur d'impulsions de courant du système de détection du système de détection de la figure 7.

## Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à une sonde dans une position normale d'utilisation.

Sauf précision contraire, les expressions "environ", "approximativement", "sensiblement", et "de l'ordre de" signifient à 10 % ou à 10° près, de préférence à 5 % ou à 5° près. En outre, on considère ici que les termes "isolant" et "conducteur" signifient respectivement "isolant électriquement" et "conducteur électriquement".

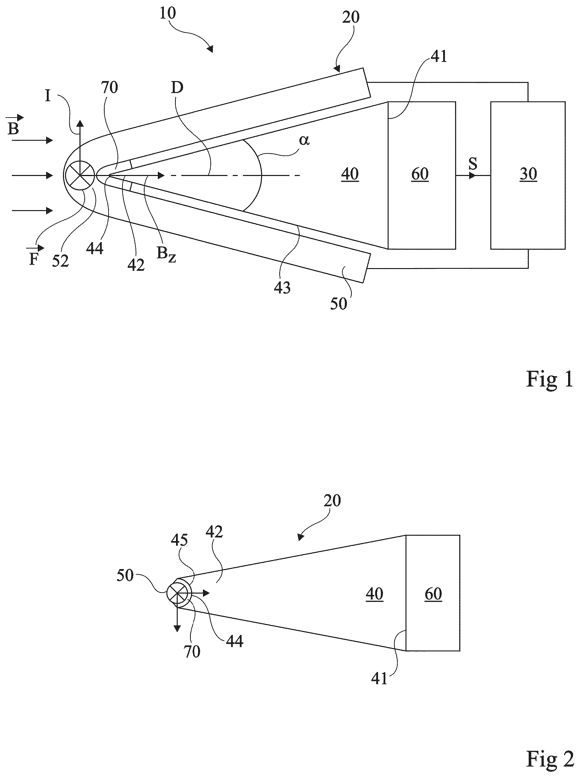

La figure 1 est une vue en coupe, partielle et schématique, d'un mode de réalisation d'un système 10 de détection d'une composante $B_z$ d'un champ magnétique $\vec{B}$.

Le système 10 comprend un dispositif 20 de détection de champ magnétique, appelé sonde par la suite, et un dispositif de commande et d'acquisition 30 relié à la sonde 20. La sonde 20 comprend un guide d'ondes acoustiques 40, un fil conducteur électriquement 50, et un transducteur électroacoustique 60.

Le guide d'ondes acoustiques 40 a une forme fuselée selon un axe D avec une section droite dont la surface diminue depuis une base 41 jusqu'à une extrémité effilée 42, appelée pointe par la suite, opposée à la base 41. Le guide d'ondes acoustiques 40 est appelé guide fuselé 40 par la suite. Le fil conducteur 50 s'étend le long de la paroi latérale 43 du guide fuselé 40 jusqu'à la pointe 42. Selon un mode de réalisation, le fil conducteur 50 est replié sur la pointe 42 et fixé à la pointe 42 par un matériau de collage 70.

Selon un mode de réalisation, le guide fuselé 40 a une forme générale de cône ou de cône tronqué. De préférence, le guide fuselé 40 présente une symétrie de révolution autour de l'axe D. Selon un autre mode de réalisation, le guide fuselé 40 a une forme générale prismatique, notamment à base triangulaire. Au moins dans un plan contenant l'axe D, le guide fuselé 40 a une section droite triangulaire d'angle au sommet α inférieur à 15 °, de préférence inférieur à 10 °, plus préférentiellement inférieur à 5 °. Lorsque le guide fuselé 40 a une forme générale de cône ou de cône tronqué, l'angle au sommet α correspond à l'angle au somment du cône. Lorsque le guide fuselé 40 a une forme générale de prisme à base triangulaire, l'angle au sommet α correspond à l'angle au sommet de la base triangulaire du côté de la pointe 42 du guide fuselé 40. Le fil conducteur 50 présente une portion 52 recouvrant la pointe guide fuselé 40 dans laquelle le courant circule sensiblement de façon perpendiculaire à l'axe D du guide fuselé 40.

En fonctionnement, la pointe 42 du guide fuselé 40 est placée à l'endroit où se trouve le champ magnétique $\vec{B}$. Le système 10 permet de mesurer la composante $B_z$, selon l'axe D du guide fuselé 40, du champ magnétique $\vec{B}$.

Selon un mode de réalisation, le fil conducteur 50 a une section droite cylindrique. Selon un autre mode de réalisation, le fil conducteur 50 a une section droite qui n'est pas cylindrique. Dans le cas où le fil conducteur 50 a une section droite qui n'est pas cylindrique, on appelle diamètre du fil conducteur 50 le diamètre du disque de même surface que la surface de la section droite du fil conducteur 50. Selon un mode de réalisation, le fil conducteur 50 a un diamètre variant de 10 μm à 200 μm, par exemple égal à environ 40 μm. Selon un mode de réalisation, le fil conducteur 50 comprend un coeur conducteur entouré d'une gaine isolante, par exemple un fil émaillé. Selon un autre mode de réalisation, le fil conducteur 50 correspond à une piste conductrice déposée sur le guide fuselé 40.

Selon un mode de réalisation, la pointe 42 du guide fuselé 40 comprend une surface 44, appelée surface d'appui 44 par la suite, sur laquelle repose la portion 52 du fil conducteur 50.

Selon un mode de réalisation, la surface d'appui 44 est plane et perpendiculaire à l'axe D du guide fuselé 40. Selon un mode de réalisation, la surface d'appui 44 est inscrite dans un disque. On appelle alors diamètre de la surface d'appui 44 le diamètre du disque dans lequel est inscrite la surface d'appui 44. Selon un mode de réalisation, la surface d'appui 44 n'est pas plane. Dans ce cas, on appelle diamètre de la surface d'appui 44 le diamètre du disque dans lequel est inscrite la surface d'appui 44 lorsqu'elle est vue selon l'axe D.

Selon un mode de réalisation, la surface d'appui 44 a un diamètre compris entre le diamètre du fil conducteur 50 et le quintuple du diamètre du fil conducteur 50, par exemple entre le double et le quintuple du diamètre du fil conducteur 50. Selon un mode de réalisation, la surface d'appui 44 a un diamètre compris entre le double et le quintuple du diamètre du fil conducteur 50. Selon un mode de réalisation, la surface d'appui 44 a un diamètre égal au diamètre du fil conducteur 50. Le pourtour de la surface d'appui 44 constitue alors une surface d'appui protégeant le fil conducteur 50. Plus le diamètre du fil conducteur 50 est proche du diamètre de la surface d'appui 44 et moins des effets de propagation dans le voisinage de la pointe 42 se font ressentir. A titre d'exemple, pour un fil conducteur 50 de diamètre égal à 40 μm, le diamètre de la surface d'appui 44 peut être voisin de 100 μm.

En outre, pour éviter d'écraser le fil conducteur 50 lors des mesures, une encoche de profondeur égale au diamètre du fil conducteur 50 peut être réalisée dans le plan de la surface d'appui 44 de façon à enterrer le fil conducteur 50 dans la pointe 42.

La figure 2, la figure 3, la figure 4, et la figure 5 sont des vues en coupe, partielles et schématiques, d'autres modes de réalisation de la sonde 20. Le plan de coupe des figures 2 à 5 contient l'axe D du guide fuselé 40 et est perpendiculaire au plan de coupe de la figure 1.

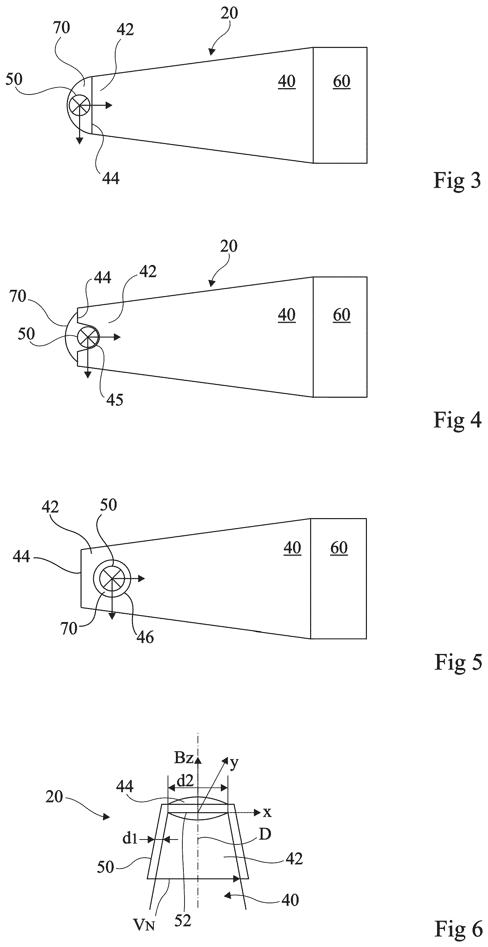

Dans le mode de réalisation illustré en figure 2, le diamètre de la surface d'appui 44 est égal au diamètre du fil conducteur 50, et la surface d'appui 44 comprend une encoche 45 dans laquelle est enfoui le fil conducteur 50. Ce mode de réalisation est adaptée notamment pour les champs magnétiques de faibles amplitudes. Le matériau de collage 70 peut être réparti dans l'encoche 45. La portion 52 du fil conducteur 50 reposant sur la face d'appui 44 s'étend de façon sensiblement rectiligne selon un axe perpendiculaire à l'axe D du guide fuselé 40. De préférence, la longueur de la portion rectiligne 52 du fil conducteur 50 ne dépasse pas une demi-longueur d'onde de la vitesse de phase des ondes transversales, soit typiquement moins de 0,5 mm à 1 MHz et 0,1 mm à 5 MHz. Le mode de réalisation illustré en figure 2 permet la détection du champ magnétique $\vec{B}$ avec la meilleure résolution spatiale par rapport aux modes de réalisation illustrés sur les figures 3 à 5.

Dans le mode de réalisation illustré en figure 3, la surface d'appui 44 est plane et le diamètre de la surface d'appui 44 est égal à environ 3 fois le diamètre du fil conducteur 50. Le fil conducteur 50 est posé à plat sur la surface d'appui 44 et est protégé par le matériau de collage 70.

Dans le mode de réalisation illustré en figure 4, le diamètre de la surface d'appui 44 est égal à environ 3 fois le diamètre du fil conducteur 50 et la surface d'appui 44 comprend une encoche 45 dans laquelle est enfoui le fil conducteur 50.

Dans le mode de réalisation illustré en figure 5, le guide fuselé 40 comprend une ouverture traversante 46 dans la pointe 42 à proximité de l'extrémité de la pointe 42, par exemple à une distance de l'extrémité de la pointe 42 variant de une fois à deux fois le diamètre du fil conducteur 50. Le diamètre de l'ouverture traversante 46 est légèrement supérieur au diamètre du fil conducteur 50, et le fil conducteur 50 passe par l'ouverture 46. Le fil conducteur 50 est couplé de façon rigide au guide fuselé 40 par le matériau de collage 70 ou par compression et déformation de l'extrémité de la pointe 42 qui vient légèrement pincer le fil conducteur 50.

Les modes de réalisation illustrés sur les figures 3, 4, et 5 sont avantageusement plus robustes que le mode de réalisation illustré en figure 2. Les modes de réalisation illustrés sur les figures 3, 4, et 5 sont notamment adaptés à des applications pour lesquelles on envisage de pouvoir mettre la sonde 20 en contact avec une surface aimantée. En outre, les risques d'écrasement du fil conducteur 50 dans les modes de réalisation illustrés sur les figures 4 et 5 sont réduits par rapport aux modes de réalisation illustrés sur les figures 2 et 3.

Plus le diamètre de la surface d'appui 44 est grand et moins il y a de perturbation de la mesure lorsque la pointe 42 entre en contact avec une surface dure. En effet, l'impédance de rayonnement de la pointe 42 chute considérablement lorsque l'on se rapproche de l'extrémité de la pointe 42. Son blocage par une surface dure pourrait limiter l'amplitude de l'impulsion mécanique engendrée par la force de Lorentz qui s'applique sur un petit volume de matière, latéralement libre. Cela pourrait fausser la mesure en diminuant l'amplitude du signal. En outre le contact de la pointe 42 avec un milieu solide peut engendrer des ondes ultrasonores dans le milieu qui peuvent revenir dans la pointe 42 et fausser la mesure.

De façon avantageuse, l'encombrement latéral de la pointe 42 de la sonde 20 est au moins dix fois plus faible que l'encombrement latéral des sondes à effet Hall disponibles actuellement dans le commerce.

Selon un mode de fonctionnement du système 10, appelé mode de fonctionnement direct par la suite, le dispositif de commande et d'acquisition 30 est configuré pour commander le transducteur électroacoustique 60 pour la génération d'une onde acoustique dans le guide fuselé 40. En mode de fonctionnement direct, le guide fuselé 40 permet de propager l'onde ultrasonore depuis la base 41 jusqu'à la pointe 42. L'onde ultrasonore entraîne une flexion de la pointe 42. Le déplacement de la pointe 42, et donc du fil conducteur 50 dans le champ magnétique $\vec{B}$ entraîne l'apparition d'une force électromotrice FEM dans le fil conducteur 50. La force électromotrice FEM est proportionnelle à la composante $B_z$ du champ magnétique $\vec{B}$ à mesurer. Le dispositif de commande et d'acquisition 30 est configuré pour mesurer la force électromotrice FEM aux extrémités du fil conducteur 50 et à en déduire la composante $B_z$ du champ magnétique $\vec{B}$ et la polarisation du champ magnétique $\vec{B}$ présent à la pointe 42 du guide fuselé 40.

Dans le mode de fonctionnement direct, la force de Lorentz appliquée à la portion 52 du fil conducteur 50 située sur la pointe 42 du guide fuselé 40 a une amplitude maximale $F_{max}$ donnée par la relation suivante :

[Math 1]

$$F_{max} = Q v_{max} B_z$$

où Q est la charge d'espace située à l'extrémité du fil conducteur 50, et $v_{max}$ est la vitesse maximale de battement de la pointe 52 du cône fuselé 40. Il en résulte une tension $V_N$ aux extrémités du fil conducteur 50.

La figure 6 est une vue en perspective, partielle et schématique, de l'extrémité de la sonde 20 de la figure 3 illustrant un exemple de détermination de la charge d'espace Q.

Le fil conducteur 50 a un diamètre $d_1$ et surmonte la surface d'appui 44 de diamètre d2 à la pointe 42 du guide fuselé 40 d'axe D. Le fil conducteur 50 correspond à un certain volume de charges d'espace vibrant dans la direction Y.

La tension $V_N$ aux bornes du fil conducteur 50 est donnée par la relation suivante, obtenue en explicitant le fait que la force de Lorentz est équilibrée par la force de Coulomb :

[Math 2]

$$V_N = (d_2 + 2d_1) v_{max} B_z$$

Selon un mode de fonctionnement du système 10, appelé mode de fonctionnement inverse ou mode de fonctionnement réciproque par la suite, le dispositif de commande et d'acquisition 30 est configuré pour fournir une impulsion de courant dans le fil conducteur 50. L'impulsion de courant a une intensité I et une durée $\Delta t$, également appelée largeur d'impulsion par la suite. En présence du champ magnétique $\vec{B}$ au niveau de la pointe 42 du guide fuselé 40, il apparaît dans la partie du fil conducteur 50 située à la pointe 42 du guide fuselé 40 une force de Lorentz $\vec{F}$ dont l'amplitude F est définie par la relation suivante :

[Math 3]

$$F=I\Delta t v_e B_z$$

où $v_e$ est la vitesse des électrons dans le fil conducteur 50.

Dans le mode de fonctionnement réciproque, le guide fuselé 40 permet de transformer la force de Lorentz $\vec{F}$ en une onde de flexion ultrasonore impulsionnelle qui reste large bande durant sa propagation dans le guide fuselé 40. L'amplitude de l'onde de flexion ultrasonore est notamment proportionnelle à la composante $B_z$ du champ magnétique $\vec{B}$ à mesurer, à l'intensité I de l'impulsion de courant, et à la durée $\Delta t$ de l'impulsion de courant. L'onde de flexion est polarisée dans le sens du produit vectoriel $\vec{I} \wedge \vec{B}$ perpendiculairement au plan de la figure 1 défini par l'axe D et la tangente au fil conducteur 50 définissant le vecteur courant $\vec{I}$ là où le fil conducteur 50 est rigidement fixé à l'extrémité de la pointe 42. En raison de sa forme générale effilée avec un faible angle au sommet, le guide fuselé 40 favorise la propagation d'un mode acoustique de flexion engendré à l'extrémité de la pointe 42 jusqu'à la base 41. L'impédance intrinsèque du matériau constituant le guide fuselé 40 est égale au produit de la vitesse fondamentale d'une onde transversale dans le matériau par la densité du matériau. On définit l'impédance mécanique de rayonnement de la pointe 42 du guide fuselé 40 comme le produit de la vitesse de phase d'une onde acoustique à l'endroit du couplage par la densité du matériau constituant le guide fuselé 40. L'impédance mécanique de rayonnement est particulièrement faible, typiquement 3 à 4 fois plus faible que l'impédance intrinsèque du matériau. Cette caractéristique est avantageusement adaptée à un transfert efficace de la force de Lorentz apparaissant dans le fil conducteur 50 rigidement couplé à la pointe 42 par collage. L'onde acoustique atteint le transducteur électroacoustique 60 qui la convertit en un signal électrique de mesure analogique S, par exemple une tension. Le dispositif de commande et d'acquisition 30 est configuré pour mesurer le signal électrique S fourni par le transducteur électroacoustique 60 et en déduire l'amplitude de la composante $B_z$ du champ magnétique $\vec{B}$ et la polarisation du champ magnétique $\vec{B}$ présent à la pointe 42 du guide fuselé 40.

Selon un mode de réalisation, l'intensité I de l'impulsion de courant est de préférence aussi élevée que possible, en pratique entre 1 A et 100 A, de préférence environ 50 A. Selon un mode de réalisation, la durée $\Delta t$ de l'impulsion de courant est aussi courte que possible, par exemple entre 1 ns et 500 ns, de préférence environ 10 ns. Dans le cas où le champ magnétique à mesurer correspond à une impulsion magnétique, la durée $\Delta t$ de l'impulsion de courant est inférieure à la durée de l'impulsion magnétique à mesurer. Dans le cas où le champ magnétique à mesurer correspond à un champ magnétique sinusoïdal, la durée $\Delta t$ de l'impulsion de courant est inférieure à la demi-période du champ magnétique sinusoïdal à mesurer. De façon générale, dans le cas où le champ magnétique à mesurer varie dans le temps, la durée $\Delta t$ de l'impulsion de courant est inférieure à la demi-période correspondant à la fréquence de variation maximale du champ magnétique.

En mode de fonctionnement réciproque, le guide fuselé 40 introduit avantageusement un retard de propagation acoustique de 1 $\mu$s à 100 $\mu$s entre l'impulsion électrique présente à la pointe 42 du guide fuselé 40 et la fourniture du signal électrique S par le transducteur électroacoustique 60. Ceci permet d'éviter le parasitage d'amplificateur de réception du dispositif de commande et de détection 30 par un couplage aérien direct entre l'impulsion électrique et l'électronique de réception.

Le fil conducteur 50, par exemple en cuivre, a une masse volumique $\mu_{Cu}$ et une section droite $S_{Cu}$. Le guide fuselé 40, par exemple en aluminium, a une masse volumique $\mu_{Al}$ et une section droite $S_{Al}$, considérée localement comme un cylindre de hauteur $\lambda/2$ où $\lambda$ est la longueur d'onde de l'onde de flexion à l'extrémité de la pointe 42. La masse totale M de matière mise en mouvement par la force de Lorentz est donnée approximativement par la relation suivante :

[Math 4]

$$M=\mu_{Cu}S_{Cu}(d_2+2d_1)+\mu_{Al}S_{Al}\frac{\lambda}{2}$$

On peut approximer la vitesse maximale $v_{max}$ de l'amplitude de vibration engendrée dans la pointe 42 par la relation suivante :

[Math 5]

$$v_{max}=\frac{(d_2+2d_1)\cdot I\cdot\Delta t\cdot B_z}{\mu_{Cu}S_{Cu}(d_2+2d_1)+\mu_{Al}S_{Al}\frac{\lambda}{2}}$$

Cette onde de flexion se propage dans le guide fuselé 40 dont le gain caractéristique est g(z) où z est une abscisse négative le long de l'axe D du guide fuselé 40 avec g(0) correspondant au gain à l'extrémité de la pointe 42 et g(H) au gain à la base 41 du guide fuselé 40 de hauteur H mesurée selon l'axe D.

Lorsque le guide fuselé 40 correspond à un cône, le gain g empirique d'une vibration mécanique d'amplitude u(x) mesurée sur l'axe D du cône, pour un mode de flexion se propageant le long du cône peut être approximé par la relation suivante :

[Math 6]

$$g(x,0)=\frac{u(x)}{u_{ref}(z_{ref})}=\frac{G_C H}{H+K(1-G_C)x}$$

où $G_C$ correspond au gain du cône mesuré à l'extrémité de la pointe 42 par rapport à une amplitude de vibration de référence mesurée à une abscisse $z_{ref}$, mesurée selon l'axe D, égale à -H/K. Le paramètre K est une constante caractéristique de la vitesse de variation du gain mécanique au voisinage de l'extrémité de la pointe 42. A titre d'exemple, pour un cône en aluminium dont la hauteur H est égale à 84 mm, la constate K est égale à 11,2, le gain $G_C$ est égal à 12,4 et l'abscisse $z_{ref}$ est égale à 7,5 mm. A la base du cône, le gain g(-H,0) est égal à 130, c'est-à-dire que le cône offre un gain mécanique transverse d'environ un facteur 130.

Lorsque l'onde de flexion parvient au niveau de la face externe du transducteur 60, la vibration mécanique $v_1$ correspondant à un déplacement mécanique $u_1$ est transformée sous haute impédance de charge électrique (et dans le cas où la face arrière du transducteur 60 est soit bloquée soit beaucoup plus faible) en une tension électrique $V_3$ aux bornes du transducteur 60 que l'on peut exprimer approximativement par la relation suivante :

[Math 7]

$$V_3=h\cdot u_1=\frac{h}{\omega}V_1$$

où h est la constante piézoélectrique et $\omega$ est la pulsation angulaire qui est égale à $2\pi f$ où f est la fréquence d'oscillation de l'onde de flexion. Si l'on exprime le fait que la vibration mécanique $v_1$ est simplement la vibration mécanique v à l'extrémité de la pointe 42 divisée par le gain du cône, on obtient la relation suivante :

[Math 8]

$$V_3=\frac{h}{\omega\cdot g(-H)}\cdot\frac{(d_2+2d_1)\cdot I\cdot\Delta t\cdot B_z}{\rho_{Cu}S_{Cu}(d_2+2d_1)+\rho_{Al}S_{Al}\frac{\lambda}{2}}$$

Les relations Math 2 et Math 8 sont deux formules modélisant la tension de sortie de la sonde 20 en fonction de ses paramètres de fonctionnement. La relation Math 2 correspond au cas où le transducteur 60 est actif et engendre après un délai de propagation Tr dans le guide fuselé 40 un battement amplifié de la pointe 42 et une tension électrique $V_N$ aux bornes du fil conducteur 50 en présence du champ magnétique $B_z$, et la relation Math 8 correspond au cas où une impulsion de courant I d'échantillonnage du champ magnétique $B_z$ engendre une flexion qui se transforme en onde qui se propage jusqu'à la base 41 du guide fuselé 40 et est convertie en une tension électrique $V_3$ aux bornes du transducteur 60.

Selon le principe de réciprocité ces deux formules fournissent la même forme de signal sous réserve que les phénomènes soient linéaires. Cependant, une différence dans les impédances d'entrée et de sortie entre le mode de fonctionnement direct dans lequel le transducteur 60 est émetteur et le mode de fonctionnement réciproque dans lequel le courant impulsionnel de mesure est à faible impédance source est avantageuse pour le mode de fonctionnement réciproque. En effet, avec un guide fuselé 40 correspondant à un cône tronqué en aluminium de hauteur H égale à 85 mm et de diamètre de base égal à 7 mm tronquée avec une surface d'appui 44 ayant un diamètre $d_2$ égal à 0,2 mm, et avec un fil conducteur 50 de cuivre émaillé de diamètre $d_1$ égal à 100 $\mu$m, nous obtenons dans le mode de fonctionnement réciproque en utilisant un amplificateur de gain 66 dB (2000 en linéaire) une sensibilité $V_3$ égal à 9I avec I exprimé en Ampères, soit pratiquement 630 V/T pour un courant de 70 A, tandis que dans le mode de fonctionnement direct, nous obtenons $V_N$ égal à 10 mV/T pour une impulsion de tension de 300 V, ce qui conduit à une sensibilité de 20V/T après un gain de 66 dB.

En mode de fonctionnement réciproque, pour que la tension $V_3$ soit significative, le courant impulsionnel I d'échantillonnage doit donc être aussi fort que possible. Néanmoins, il existe une certaine limite due à un effet décrit par la suite, appelé effet thermoacoustique, qui introduit une non-linéarité.

Selon un mode de réalisation, le fil conducteur 50 comprend au moins un coeur en un matériau conducteur électriquement, éventuellement entouré d'une gaine isolante électriquement. Selon un mode de réalisation, le matériau conducteur est choisi parmi le cuivre, un matériau dont la mobilité électronique est supérieur à 30 cm²/V/s (notamment l'or, l'argent, ou un matériau semiconducteur tel le graphène), ou un mélange d'au moins deux de ces composés. La nature du conducteur composant le fil conducteur 50 est importante que ce soit pour un fonctionnement direct ou réciproque lorsque l'on désire augmenter la sensibilité de la sonde 20 aux champs magnétiques de faibles intensités. Par défaut, on peut utiliser un fil conducteur 50 en cuivre émaillé pour les champs magnétiques allant de quelques milliteslas à plusieurs dizaines de Tesla. Mais pour les applications nécessitant une forte sensibilité aux champs magnétiques de faibles intensités, typiquement lorsqu'ils sont comparables ou inférieurs au millitesla ou au champ magnétique terrestre, on peut faire appel à des matériaux dont la mobilité électronique est plus élevée que celle du cuivre (qui est égale à 30 cm²/V/s), par exemple l'or (43 cm²/V/s), l'argent (68 cm²/V/s) ou des matériaux semiconducteurs tels le graphène. On peut aussi choisir un fil de cuivre recouvert d'une couche de graphène dont la mobilité électronique peut atteindre 200 000 cm²/V/s. La tension électrique qui apparaît aux bornes du fil conducteur 50 en mode direct est ainsi augmentée par la plus forte mobilité électronique du matériau constituant le fil conducteur 50 et la sonde 20 produit un signal exploitable et un rapport signal sur bruit amélioré aux champs magnétiques plus faibles par rapport au cas où l'on aurait simplement utilisé un fil conducteur 50 de cuivre émaillé.

Selon un mode de réalisation, le guide fuselé 40 est en un matériau solide non magnétique, notamment un matériau choisi dans le groupe comprenant le verre, le silicium, la céramique, les composites d'alumine-zircone, les métaux non magnétiques (notamment l'aluminium, le cuivre, ou le titane), l'acier austénitique et les alliages de métaux non magnétiques, notamment les alliages à base d'aluminium, de cuivre, et/ou de titane.

Le guide fuselé 40 permet, de par sa forme géométrique effilée, de réaliser de façon avantageuse un tampon thermique entre la zone de mesure à la pointe 42 et une zone de réception au niveau du transducteur électroacoustique 60. La zone de mesure peut alors être portée à une température élevée de plusieurs centaines de degrés Celsius tandis que la zone de réception peut être soumise à une température plus basse compatible avec la plage de température tolérée par le transducteur électroacoustique 60.

Le matériau de collage 70 peut être une résine cyanoacrylate, ou une résine époxy, ou une résine polyimide, ou une résine céramique, ou un verre fondu, ou une poudre frittée ou un émail enrobant le fil conducteur 50. Selon un mode de réalisation, le matériau de collage 70 est adapté pour résister aux hautes températures, par exemple jusqu'à 1000°C, ou jusqu'à la plus petite des températures de fusion de la pointe 42 du guide fuselé 40, et la température de fusion du fil conducteur 50. Le matériau de collage 70 correspond par exemple à la colle haute température commercialisée sous l'appellation Ceramabond par la société Aremco.

Dans le mode de fonctionnement réciproque, le transducteur acoustique 60 est configuré pour recevoir une onde acoustique et fournir un signal électrique analogique, par exemple une tension ou un courant, appelé signal de mesure par la suite. L'amplitude du signal de mesure dépend de l'amplitude de l'onde acoustique, de préférence est proportionnelle à l'amplitude de l'onde acoustique. Dans le mode de fonctionnement réciproque, le transducteur acoustique 60 reçoit un paquet et fournit un signal électrique de mesure comprenant au moins un pic, et de façon générale plusieurs pics positifs et négatifs. Dans le mode de fonctionnement direct, le transducteur acoustique 60 est configuré pour recevoir un signal électrique analogique, par exemple une tension ou un courant, appelé signal de commande par la suite, et fournir une onde acoustique. L'amplitude de l'onde acoustique dépend de l'amplitude du signal de commande, de préférence est proportionnelle à l'amplitude du signal de commande. Le transducteur acoustique 60 peut être un transducteur acoustique à ondes transversales. Selon un mode de réalisation, le transducteur acoustique 60 est un transducteur piézoélectrique ou un transducteur acoustique électromagnétique. Le transducteur 60 correspond par exemple au transducteur piézoélectrique commercialisé par la société Evident (ex Olympus, ex Panametrics, Waltham, Ma, USA) sous l'appellation V153 qui peut présenter une fréquence centrale autour de 1 MHz.

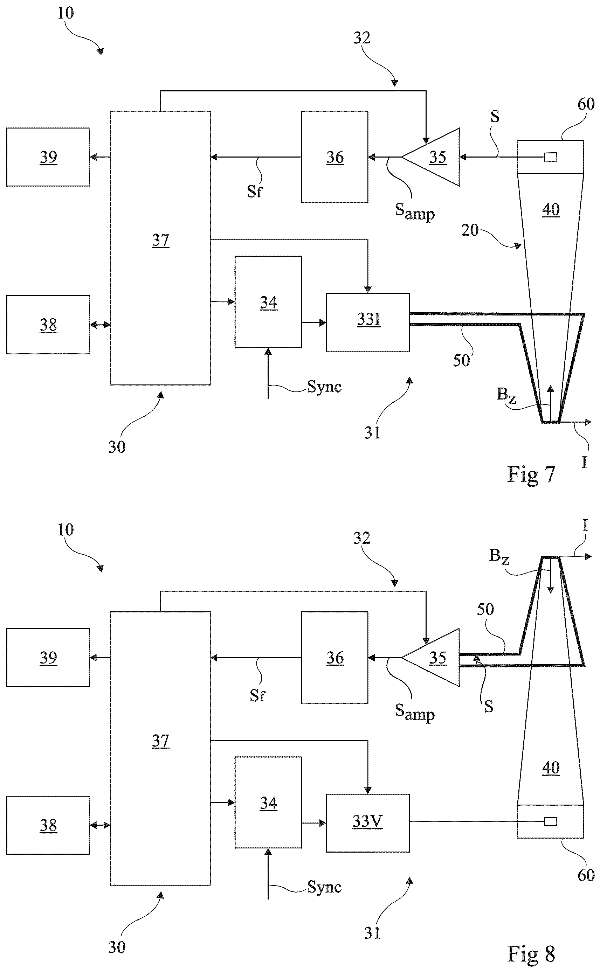

La figure 7 représente un schéma par blocs du système de détection 10 illustrant un mode de réalisation du dispositif de commande et d'acquisition 30 pour la mise en oeuvre du mode de fonctionnement réciproque. Selon un mode de réalisation, le transducteur électroacoustique 60 est un transducteur piézoélectrique.

Le dispositif de commande et d'acquisition 30 comprend notamment une chaîne de commande 31 et une chaîne d'acquisition 32. La chaîne de commande 31 comprend :

- un générateur 33I d'impulsions de courant dans le fil conducteur 50 relié aux deux extrémités du fil conducteur 50 ; et
- un module de commande 34 du générateur d'impulsions de courant 33I recevant un signal de synchronisation Sync.

La chaîne d'acquisition 32 comprend :

- un amplificateur 35 programmable recevant le signal de mesure analogique S fourni par le transducteur électroacoustique 60, égal par exemple à la tension aux bornes du transducteur électroacoustique 60, et fournissant un signal de mesure analogique amplifié $S_{amp}$ sensiblement égal au signal de mesure S multiplié par un gain d'amplification G1 ; et
- un module de traitement 36 recevant le signal de mesure amplifié $S_{amp}$ fourni par l'amplificateur 35 et fournissant un signal de mesure $S_f$ égal au signal de mesure amplifié $S_{amp}$ auquel différents traitements ont été appliqués, par exemple un filtrage.

Le dispositif de commande et d'acquisition 30 comprend en outre :

- un microcontrôleur 37 relié à l'amplificateur 35, au module de traitement 36, au module de commande 34, et au générateur 33I ;
- un ordinateur 38 relié au microcontrôleur 37 ; et
- une interface homme-machine 39 reliée au microcontrôleur 37 et/ou à l'ordinateur 38 et comprenant notamment un écran d'affichage.

A titre de variante, le module de commande 34 et/ou le module de traitement 36 peuvent être intégrés au microcontrôleur 37. La chaîne d'acquisition 32 peut comprendre un oscilloscope, par exemple l'oscilloscope commercialisé sous l'appellation Pico 5242A par la société Pico Technology.

Le dispositif de commande et d'acquisition 30 illustré en figure 7 est configuré pour la génération d'une impulsion de courant dans le fil conducteur 50 d'intensité I et de durée $\Delta t$ et se produisant éventuellement après l'écoulement d'un délai Td suivant une impulsion du signal de synchronisation Sync dans le cas d'une mesure synchrone.

L'ordinateur 38 est configuré pour échanger des signaux avec le microcontrôleur 37, par exemple via un port UART (sigle anglais pour Universal asynchronous receiver-transmitter), notamment les valeurs du délai Td, de la durée $\Delta t$, de l'intensité I, et la valeur du gain G1 de l'amplificateur programmable 35.

Selon un mode de réalisation, la valeur du gain G1 de l'amplificateur programmable 35 est déterminée à partir de l'amplitude $B_z$ du champ magnétique déterminée au cours de la mesure précédente. Plus l'amplitude $B_z$ déterminée lors de la mesure précédente est faible, plus la valeur du gain G1 est grande, par exemple selon des paliers correspondant à des plages de mesure de l'amplitude $B_z$.

Selon un mode de réalisation, le déclenchement du processus de mesure se produit à partir du signal synchronisation Sync si la mesure est synchrone. Selon un autre mode de réalisation, le déclenchement du processus de mesure se produit de façon automatique et périodique avec une période de mesure définie par l'utilisateur si la mesure est asynchrone. Dans ce cas, la période de mesure est de préférence supérieure au temps d'amortissement de l'impulsion acoustique se propageant dans le guide fuselé 40 dû à l'impulsion de courant précédente.

Selon un mode de réalisation, le générateur 33I applique une impulsion de courant d'intensité I dans le fil conducteur 50 couplé à la pointe 42 du guide fuselé 40 avec un délai Td et une durée $\Delta t$ définies dans le module de commande 34. En présence du champ magnétique $\vec{B}$, une onde acoustique ultrasonore, dont l'amplitude crête est proportionnelle à la composante $B_z$, remonte de la pointe 42 vers la base 41 du guide fuselé 40. L'onde acoustique est convertie en signal électrique de mesure S par le transducteur acoustique 60 couplé à la base 41, et le signal électrique de mesure S est amplifié par l'amplificateur programmable 35 pour fournir le signal de mesure amplifié $S_{amp}$.

Selon un mode de réalisation, le module de traitement 36 est configuré pour détecter l'amplitude de crête du signal de mesure amplifié $S_{amp}$ et fournir une valeur analogique de l'amplitude crête détectée au microcontrôleur 37. Selon un mode de réalisation, le module de traitement 36 est en outre configuré pour déterminer une valeur binaire Polar I/O représentative du signe positif ou négatif de la première impulsion du signal de mesure amplifié $S_{amp}$. En effet, la phase de l'onde acoustique change de 180° selon que la polarisation de la composante $B_z$ est orientée dans un sens ou le sens opposé. Le microcontrôleur 37 peut en outre comprendre un convertisseur analogique/numérique adapté à recevoir la valeur analogique de l'amplitude crête détectée et fournir un signal numérique de l'amplitude crête.

Selon un mode de réalisation, le microcontrôleur 37 est configuré pour recevoir directement le signal de mesure amplifié $S_{amp}$ et réaliser un échantillonnage du signal de mesure amplifié $S_{amp}$, par exemple sur une profondeur de 10 à 16 bits et à une cadence de 5 à 12 méga échantillons par seconde sur une fenêtre temporelle de 1 $\mu s$ à 100 $\mu s$. Selon un mode de réalisation, le microcontrôleur 37 est configuré pour réaliser une interpolation des points de mesure de façon à reconstituer finement le signal de mesure amplifié et obtenir une valeur précise de l'amplitude crête et de la phase du signal de mesure amplifié.

Selon un autre mode de réalisation, le microcontrôleur 37 est configuré pour déterminer la transformée de Fourier du signal de mesure amplifié $S_{amp}$. De préférence, la transformée de Fourier est déterminée à partir de la trace temporelle du signal de mesure amplifiée $S_{amp}$ incluant les pics du signal de mesure amplifié $S_{amp}$ et en excluant le couplage parasite de l'impulsion de courant ou de tension de sorte qu'il ne reste dans la trace temporelle que les pics dus à la réception du paquet d'ondes acoustiques par le transducteur 60 avec un signal de mesure nul avant son arrivée et après son arrivée.

Selon un mode de réalisation, le signal de mesure amplifié $S_{amp}$ est traité de façon à ce que ses valeurs soient nulles après le quatrième ou cinquième passage à zéro du signal de mesure amplifié $S_{amp}$, ce qui correspond au moment où l'essentiel du paquet d'ondes acoustiques a été reçu par le transducteur 60 et que l'on entre dans la queue du paquet d'ondes acoustiques. La raie spectrale d'amplitude maximale du spectre obtenu correspond à la fréquence centrale du paquet d'ondes acoustiques. L'amplitude de la raie spectrale est représentative de la valeur d'amplitude maximale du signal de mesure amplifié $S_{amp}$.

La détermination de l'amplitude crête du signal de mesure amplifié $S_{amp}$ à partir de la transformée de Fourier du signal de mesure amplifié $S_{amp}$ plutôt que directement à partir du signal de mesure amplifié $S_{amp}$ est plus précise et plus indépendante du bruit analogique existant au niveau du signal de mesure amplifié $S_{amp}$. Ceci permet d'accéder à des champs magnétiques faibles proches du champ magnétique terrestre. Dans ces cas extrêmes, la sensibilité est augmentée en remplaçant l'impulsion de courant par un train d'impulsions, comprenant par exemple 2 à 10 impulsions et préférentiellement 4 impulsions de courant équidistantes, avec une porteuse centrée sur la fréquence centrale du transducteur électromécanique 60. En outre, de façon avantageuse, la transformée de Fourier du signal de mesure amplifié $S_{amp}$ est indépendante de la durée de propagation des ondes acoustiques dans le guide fuselé 40. L'effet d'un changement de température du guide fuselé 40 se résume alors à une avance ou un retard d'arrivée du paquet d'ondes acoustiques au transducteur 60, soit simplement un changement de phase dans l'espace de Fourrier.

Le microcontrôleur 37 est configuré pour déterminer la valeur du champ $B_z$ en multipliant la valeur crête par un coefficient d'étalonnage. La valeur du champ magnétique $B_z$ et sa polarisation (nord, sud) sont affichées sur l'afficheur 39 dans une unité de mesure choisie ou transmise à l'ordinateur 38 pour un traitement complémentaire.

Selon un mode de réalisation, le dispositif de commande et d'acquisition 30 peut piloter une, deux, ou plus de deux sondes 20 à partir du même signal de synchronisation Sync, chacune des sondes 20 pouvant être excitée avec un délai Td identique ou différent par rapport aux autres sondes 20 de sorte que l'on peut multiplier l'échantillonnage spatial et temporel par le nombre de sondes 20 utilisées. Si plusieurs sondes 20 sont excitées avec des délais Td légèrement différents et disposées pratiquement au même endroit d'une source magnétique relativement étendue spatialement mais oscillant très rapidement, on peut multiplier le nombre de points d'échantillonnage du champ magnétique par le nombre de sondes 20 utilisées.

La figure 8 représente un schéma par blocs du système de détection 10 illustrant un mode de réalisation du dispositif de commande et d'acquisition 30 pour la mise en oeuvre du mode de fonctionnement direct. Le dispositif de commande et d'acquisition 30 représenté en figure 8 comprend les mêmes éléments que le dispositif de commande et d'acquisition 30 représenté en figure 7 à la différence que le signal de mesure analogique S reçu par l'amplificateur 35 correspond à la tension aux bornes du fil conducteur 50 et que le générateur 33I d'impulsions de courant est remplacé par un générateur 33V d'impulsions de tension fournies au transducteur 60.

Un inconvénient lors de la mise en oeuvre du mode de fonctionnement réciproque est liée à l'apparition de l'effet thermoacoustique correspondant à la dilation du fil conducteur 50 lorsque l'intensité I du courant qui y circule engendre un effet joule important. L'impulsion de courant I engendre une impulsion de chaleur qui se transforme en condition adiabatique en une expansion thermique impulsionnelle.

Un premier essai a été réalisé. Dans le premier essai, la sonde 20 représentée sur la figure 1 est utilisée et le système 10 est utilisé dans le mode de fonctionnement réciproque. La hauteur H du guide fuselé 40, mesurée selon son axe de révolution D, est égale à 82 mm et le diamètre à la base 41 est égal à 7 mm. L'angle $\alpha$ au sommet du guide fuselé 40 est égal à 4,6 °. Le fil conducteur 50 a un diamètre $d_1$ égal à 40 $\mu$m. Le guide fuselé 40 est en aluminium et le fil conducteur 50 est un fil en cuivre émaillé collé avec une résine cyanoacrylate à la surface d'appui 44 du guide fuselé 40. Le transducteur électroacoustique 60 est le transducteur piézoélectrique large bande à ondes transversales commercialisé par la société Evident Technologies (Waltham, Ma, USA) sous l'appellation V153 centré sur 1 MHz. Le gain d'amplification de l'amplificateur programmable est égal à 48 dB. Pour le premier essai, la sonde 20 est utilisée dans le mode de fonctionnement réciproque et l'impulsion de courant traversant le fil conducteur 50 a une durée $\Delta t$ égale à 270 ns et a une intensité I égale à 30 A.

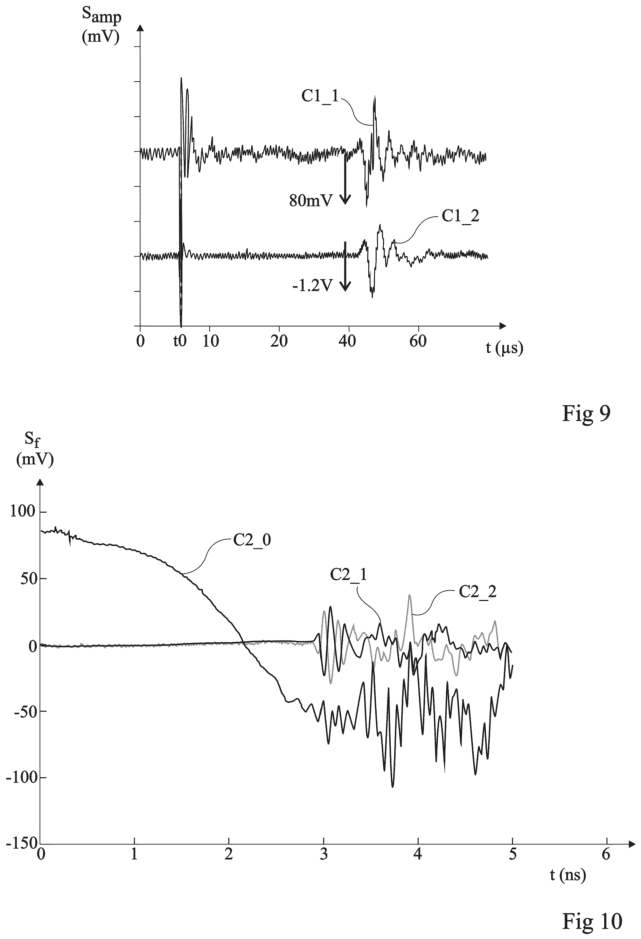

La figure 9 représente des chronogrammes C1_1 et C1_2 du signal de mesure amplifié $S_{amp}$ fourni par l'amplificateur 35 du système de détection 10 pour le premier essai. L'échelle des ordonnées est de 50 mv par graduation pour la courbe C1_1 et de 5 V par graduation pour la courbe C1_2. La courbe C1_1 est obtenue pour un champ magnétique nul et la courbe C1_1 est obtenue pour un champ magnétique dont l'amplitude est égale à 480 mT. L'instant t0 correspond à l'envoi du signal de synchronisation Sync pour la commande du générateur 33I d'impulsion de courant. Le signal de mesure amplifié $S_{amp}$ atteint 80 mV crête en l'absence de champ magnétique et est dû seulement à l'effet thermoacoustique. Le signal de mesure amplifié $S_{amp}$ en présence du champ magnétique atteint 1,2 V crête soit quinze fois plus que le signal de mesure amplifié $S_{amp}$ en l'absence du champ magnétique. En l'absence de champ magnétique, l'impulsion de courant peut donc engendrer dans le guide fuselé 40, seule, une onde acoustique parasite.

La formule suivante donne la dilatation attendue d'un fil conducteur 50 de section $S_{Cu}$ et de longueur LG, de résistivité électrique $\rho$, subissant un effet Joule pendant une largeur d'impulsion $\Delta t$ qui correspond à une énergie dissipée ΔQ. En utilisant la capacité thermique spécifique Cp du fil conducteur 50 de cuivre de masse volumique $\mu_{Cu}$, nous déduisons l'augmentation de température ΔT dans le fil conducteur 50 et, connaissant le coefficient de dilatation thermique β, nous déduisons l'augmentation de longueur libre du fil ΔLG dans des conditions adiabatiques :

[Math 9]

$$\Delta Q = \frac{\varrho \cdot W \cdot I^2 \cdot \Delta t}{S_{Cu}}$$

$$\Delta T = \frac{\varrho \cdot I^2 \cdot \Delta t}{S_{Cu}^2 \cdot \rho_{Cu} \cdot Cp}$$

$$\Delta LG = \frac{\beta \cdot W \cdot \varrho \cdot I^2 \cdot \Delta t}{S_{Cu}^2 \cdot \rho_{Cu} \cdot Cp}$$

Pour le cuivre, le coefficient de dilatation thermique β égal à $17*10^{-6}$ /°C, la résistivité électrique ρ est égale à $1,66*10^{-8}$ Ω.m, la masse volumique $\mu_{Cu}$ est égale à 8920 kg/m$^3$, et la capacité thermique spécifique Cp est égale 315 J/kg/K. En choisissant la longueur LG égale à 2 cm, le courant I égal à 60 A, la durée Δt égale à 0,5 μs, et la section $S_{Cu}$ égale à $0,75*10^{-8}$ m$^2$, alors l'énergie dissipée ΔQ est égale à 0,8 μJ/impulsion, l'augmentation de température ΔT est égale à 0,2°C/impulsion, et l'augmentation de longueur libre du fil ΔLG est égale à 64 nm et la vitesse maximale $v_{max}$ de l'amplitude de vibration engendrée dans la pointe 42 est égale à ΔW*Δt soit 0,12 m/s.

Comme on peut le voir, ce signal parasite évolue inversement avec le carré du diamètre du fil conducteur 50, et proportionnellement au carré du courant d'impulsion I et linéairement avec la réduction de la largeur d'impulsion Δt, car la chaleur ne peut pas être évacuée pendant l'impulsion, ce qui rend le processus adiabatique. En pratique, entre un fil conducteur 50 de diamètre $d_1$ égal à 40 μm et un fil conducteur 50 de diamètre $d_1$ égal à 100 μm, si l'on réduit l'impulsion de courant I de 60 A à 20 A, l'effet thermoacoustique est réduit par un facteur 56. Sachant également que le courant moyen ne doit pas dépasser 4 A/mm$^2$ dans une section du fil conducteur 50, on vérifie qu'à une cadence de tirs de 1000 impulsions/s, le courant moyen reste à un niveau acceptable de 2,5 A/mm$^2$. Enfin, si le fil conducteur 50 est étroitement couplé à la pointe 42 du guide fuselé 40, le processus n'est plus adiabatique, et la chaleur peut être plus efficacement évacuée vers le guide fuselé 40 et sa dilatation thermique à long terme est réduite, ce qui est avantageux pour éviter que le fil conducteur 50 ne se décolle.

Il est nécessaire d'éliminer cette onde acoustique parasite pour pouvoir mesurer des champs magnétiques faibles, typiquement inférieurs à 100 μT. Ceci est obtenu en mettant en oeuvre un procédé de compensation de l'effet thermoacoustique et/ou en prévoyant une structure réduisant l'effet thermoacoustique.

Selon un mode de réalisation, le procédé de compensation comprend la mesure d'un signal de compensation qui correspond au signal de mesure amplifié $S_{amp}$ obtenu en l'absence de champ magnétique, par exemple en plaçant la sonde 20 dans une cavité zéro gauss. Lors de la réalisation d'une mesure de champ magnétique, le signal de mesure amplifié et traité $S_f$ correspond à la différence entre le signal de mesure amplifié $S_{amp}$ et le signal de compensation.

Un deuxième essai a été réalisé. Dans le deuxième essai, la sonde 20 du premier essai est utilisée. Le gain d'amplification de l'amplificateur 35 est égal à 66 dB. Pour le deuxième essai, la sonde 20 est utilisée dans le mode de fonctionnement réciproque et l'impulsion de courant I traversant le fil conducteur 50 a une intensité égale à 8 A.

La figure 10 représente des chronogrammes C2_0, C2_1, et C2_2 du signal de mesure amplifié et filtré $S_f$ obtenus pour le deuxième essai. La courbe C2_0 est obtenue en présence d'un champ magnétique d'amplitude égale à -1,7 mT en l'absence de compensation. La courbe C2_1 est obtenue en présence d'un champ magnétique d'amplitude égale à 1,7 mT, le signal de mesure amplifié et filtré $S_f$ étant égal à la différence du signal de mesure amplifié $S_{amp}$ et du signal de compensation. La courbe C2_2 est obtenue en présence d'un champ magnétique d'amplitude égale à -1,7 mT, le signal de mesure amplifié et filtré $S_f$ étant égal à la différence du signal de mesure amplifié $S_{amp}$ et du signal de compensation. Les courbes C2_0, C2_1, et C2_2 sont obtenues en effectuant la moyenne de 1000 acquisitions.

Un inconvénient du mode de réalisation du procédé de compensation décrit précédemment et que si la température change, il apparaît un décalage du délai de transit dans le guide fuselé 40 de quelques nanosecondes/°C et le signal de compensation doit être mis à jour régulièrement. Dans ce mode de réalisation, les courants les plus élevés ne donnent pas la meilleure détectivité car des courants impulsionnels élevés créent une forte augmentation de température locale qui engendre ensuite des dérives lentes du temps de transit à l'intérieur du guide fuselé 40.

Un autre mode de réalisation d'un procédé de compensation comprend la fourniture d'impulsions de courant traversant le fil conducteur 50 en alternant le sens de circulation du courant traversant le fil conducteur 50 lors de deux acquisitions successives.

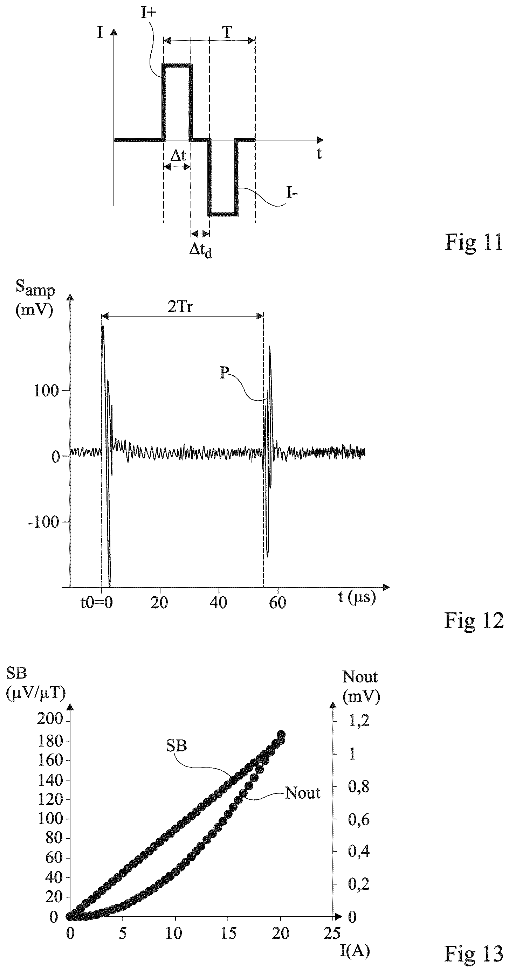

La figure 11 représente un chronogramme du courant I circulant dans le fil conducteur 50 pour la réalisation d'une mesure de champ magnétique dans le mode de fonctionnement réciproque. Le courant I comprend successivement une première impulsion de courant I+ et une deuxième impulsion de courant I- circulant dans le fil conducteur 50 dans des sens opposés. L'ensemble des deux impulsions I+ et I- est appelé impulsion bipolaire par la suite. En figure 11, les impulsions de courant I+ et I- ont chacune la forme d'un créneau. Toutefois, les impulsions de courant I+ et I- peuvent avoir une forme différente, par exemple une forme triangulaire ou sinusoïdale. On appelle T la période de l'impulsion bipolaire qui correspond à la durée entre le front montant de la première impulsion I+ et le front montant de la première impulsion I+ de l'impulsion bipolaire suivante. On appelle en outre $\Delta t$ la durée de la première impulsion I+ qui est égale à la durée de la deuxième impulsion I-. On appelle en outre $\Delta t_d$ la durée entre le front descendant de la première impulsion I+ et le front montant de la deuxième impulsion I-.

Les deux impulsions I+ et I- de courant de sens opposés créent des forces de Lorentz opposées correspondantes et des signaux de mesure analogiques S également opposés, à l'exception de la composante due à l'effet thermoacoustique, qui évolue elle selon le carré de l'intensité du courant et inversement avec le carré de la section du fil conducteur 50. Le signal de mesure amplifié et filtré $S_f$ correspond à la différence entre les deux signaux de mesure amplifiés $S_{amp}$ obtenus pour les deux impulsions I+ et I-. Un avantage du présent mode de réalisation est qu'il ne requiert pas la mesure d'un signal de compensation devant être rafraichi régulièrement.

Grâce à une faible gigue inférieure à une nanoseconde, nous pouvons soustraire efficacement deux acquisitions successives échantillonnées à une cadence élevée devant la fréquence F du signal, par exemple 62,5 Méch/s (Méga échantillons par seconde) avec 15 bits de résolution. Ceci élimine les signaux thermoacoustiques ainsi que le couplage d'impulsions parasites et les modes axiaux longitudinaux résiduels. Cette mesure différentielle double également le signal magnétique utile donc la sensibilité de la sonde 20.

Les deux impulsions de courant I+ et I- doivent être inverses mais strictement identiques en valeur absolue à 99,8 % afin de diviser le bruit thermoacoustique par un facteur de réduction égal à 500. Ceci est le facteur de réduction maximal pouvant être obtenu puisque, si l'on prend pour simplifier deux ondes sinusoïdales I+ et I- opposées mais très légèrement décalées dans le temps par un délai égal à la gigue, le taux relatif de signal résiduel après soustraction, est égal à $2.\pi.F$.gigue soit 0,18 % si la gigue est égale 0,4 ns rms et la fréquence F est égale à 700 kHz.

Alors, si la durée $\Delta t_d$ entre les deux impulsions I+ et I- opposés est suffisamment courte, par exemple égale à 1 ms, la diffusion lente des flux de chaleur apparaissant dans le fil conducteur 50 lors des impulsions I+ et I- successives n'a pas le temps de changer significativement la température de la pointe 42 du guide fuselé 40 entre deux impulsions successives au point d'engendrer une variation de temps de transit supérieure à la gigue (soit environ 0,4 ns rms) entre les deux impulsions I+ et I- opposées successives. Cette compensation est alors beaucoup plus efficace que celle qui consiste à enregistrer le signal de compensation dans une cavité zéro gauss puis soustraire ce signal aux mesures suivantes en présence d'un champ $B_z$ à mesurer. Elle est également plus efficace qu'une compensation qui consiste à faire l'acquisition de mesures avec 1000 impulsions I+ successives moyennées selon un premier sens du courant, puis 1000 impulsions I- successives moyennées selon un sens inverse du courant. En effet, en imbriquant les impulsions opposées I+ et I-, les conditions thermiques de la pointe 42 pour les deux impulsions successives I+ et I- sont toujours quasiment les mêmes.

Selon un mode de réalisation, on réalise une succession d'impulsions bipolaires, et on effectue ensuite une moyenne des couples de signaux de mesure S correspondant à des impulsions opposées pour affiner la résolution avec un recalage temporel éventuel des couples d'acquisition lorsque la variation de température est forte et rapide.

Pour pouvoir recaler temporellement un couple de signaux de mesure S en réponse à des impulsions opposées par rapport à d'autres couples de signaux de mesure S, on détermine le temps de transit Tr dans le guide fuselé 40 en fonction de la température. Dans ce but, le système de détection 10 est utilisé dans le mode de fonctionnement direct pour l'émission d'une onde acoustique par le transducteur électroacoustique 60 dans le guide fuselé 40 puis le système de détection 10 est utilisé dans le mode de fonctionnement réciproque pour la mesure par le transducteur électroacoustique 60 de l'onde acoustique réfléchie, également appelée écho. La durée entre l'instant d'émission de l'onde acoustique par le transducteur électroacoustique 60 et la réception de l'onde acoustique qui s'est réfléchie sur la pointe 42 du guide fuselé correspond au double du temps de transit Tr.

Un troisième essai a été réalisé. Dans le troisième essai, la sonde 20 utilisée pour le premier essai est utilisé à la différence que la hauteur du guide fuselé 40, mesurée selon son axe de révolution D, est égale à 84 mm.

La figure 12 est un chronogramme du signal de mesure amplifiée $S_{amp}$ mesuré par le système de détection 10 lorsqu'une onde acoustique est émise par le transducteur électroacoustique 60 et que l'onde acoustique réfléchie est mesurée par le transducteur électroacoustique 60. En figure 12, l'onde électroacoustique 60 est émise à l'instant initial t0 égal à 0 $\mu$s et les pics P du signal Samp correspond à la l'onde réfléchie atteignant le transducteur électroacoustique 60. La durée s'écoulant entre l'instant initial t0 et le premier pic du signal de mesure amplifiée $S_{amp}$ correspond au double du temps de transit Tr.

On fait alors l'acquisition de nombreux couples de signaux de mesure S obtenus en utilisant des impulsions bipolaires de courant et on effectue la moyenne des couples de signaux de mesure S obtenus, mais en prenant un premier couple de signaux de mesure S comme couple de référence et en recalant temporellement les autres couples de signaux de mesure S successifs par rapport à ce premier couple de signaux de mesure S à partir du maximum de la fonction d'intercorrélation entre le premier couple de signaux de mesure S et les couples de signaux de mesure S successifs. Il faut pour cela que la fréquence d'échantillonnage du signal soit suffisamment élevée de façon à ce que la période entre deux échantillons soit petite devant la période du signal, typiquement au moins 10 fois, et préférentiellement cinquante à 100 fois plus petite. Ainsi, pour un signal ultrasonore centré sur 700 kHz, une fréquence d'échantillonnage de 62,5 MHz (ou MSPS) correspondant à une période de 16 ns est 89 fois plus élevée que la fréquence des ultrasons et est une bonne configuration pour moyenner des couples de signaux de mesure S successif. Néanmoins, la période de 16 ns reste grande devant la gigue du générateur d'impulsions, inférieure à 0,4 ns rms et devant le décalage temporel entre les deux membres d'un couple de signaux de mesure S.

Les conditions devant nécessiter un recalage temporel entre les signaux de mesure S doivent être sévères, c'est-à-dire engendrer des écarts de température de plusieurs degrés Celsius à l'intérieur du guide fuselé 40 entre le premier couple de signaux de mesure S et celui pour lequel un premier recalage de 16 ns serait requis. Si l'on effectue une moyenne sur 1000 couples en 1 seconde, on peut calculer que l'élévation de température d'un fil conducteur 50 de diamètre $d_1$ égal à 100 $\mu$m dans lequel on fait circuler un courant I de 13,3 A pendant 0,5 $\mu$s en conditions adiabatiques augmente de moins de 20°C entre la première impulsion et la 2000ème impulsion. Ceci correspondra à un recalage de moins de 5 périodes d'échantillonnage ou 80 ns, ce qui reste près de 18 fois plus petit que la période acoustique. En outre, pour un couple de traces opposées, l'élévation de température du fil conducteur 50 entre deux impulsions les plus rapprochées possibles en conditions adiabatiques est de moins de 0,01°C. Si cette élévation de température était celle du guide fuselé 40, cette élévation représenterait une variation de temps de transit de près de dix fois inférieure à la gigue de 0,4 ns. En pratique, la chaleur produite dans le fil conducteur 50 diffuse dans tout le volume du guide fuselé 40 et l'élévation de température de l'ensemble est bien moindre. Néanmoins, si l'on porte le courant impulsionnel à 67 A, alors l'échauffement du fil conducteur 50 en condition adiabatique sera 25 fois plus grand. Cet échauffement diffusera d'abord au niveau de l'extrémité de la pointe 42 du guide fuselé 40 engendrant une variation de temps de transit Tr du paquet d'ondes et le recalage pourra s'avérer utile pour que les paires de signaux successives restent en phase sur le long terme (à l'échelle d'une seconde) et que le fait de moyenner reste avantageux pour améliorer le rapport signal/bruit.

Sachant que le signal de mesure S est échantillonné avec une période d'échantillonnage Ts égale à 1/Fs où Fs est la fréquence d'échantillonnage, si le décalage lié à la température par rapport à un signal de référence correspondant à une température de référence ou un premier signal de mesure S de référence est supérieur à une période d'échantillonnage, alors on effectue un décalage correctif temporel en sens inverse sur les signaux de mesure S ultérieurs pour pouvoir moyenner les signaux de mesure. La fréquence d'échantillonnage du signal est en pratique supérieure à 12 fois la fréquence des ultrasons et de préférence supérieure à 100 fois la fréquence des ultrasons ce qui implique une fréquence d'échantillonnage d'environ 100 MSPS (MegaSamplePerSecond), soit une période d'échantillonnage Ts égale à 10 ns.

En pratique, la sensibilité de la sonde 20 augmente linéairement avec l'intensité du courant de mesure I, tandis que le signal parasite thermoacoustique augmente avec le carré du courant I. Il existe donc une valeur seuil de courant au-delà de laquelle le bruit thermoacoustique ne peut plus être compensé soit en raison de la gigue ou alors en raison de la saturation de l'échelle du convertisseur analogique numérique voire du manque de résolution du convertisseur analogique numérique. Le bruit thermoacoustique résiduel après compensation devient alors visible lorsqu'il atteint le bruit de grenaille (de Nyquist) engendré par le réseau résistif mesuré en sortie de l'amplificateur de réception 35 (Nout). Si celui-ci est par exemple de 0,5 mV rms après un gain de 66 dB (2000 linéaire), alors il est inutile d'augmenter davantage l'intensité du courant de mesure sauf si l'on cherche à réduire la durée du temps de mesure qui réduit linéairement le bruit thermoacoustique.

La figure 13 représente une courbe d'évolution du bruit dû à l'effet thermoacoustique Nout et une courbe d'évolution SB de la sensibilité en fonction de l'intensité des impulsions de courant I. Les courbes sont obtenues avec moyennage de 1000 acquisitions successives.

A titre d'exemple, on voit en figure 13 que, lorsque le bruit Nout en sortie de l'amplificateur de réception 35 après un gain de 66 dB vaut 0.5 mV rms, la sensibilité SB de la sonde 20 pour une mesure à base de deux impulsions de courant opposées d'amplitude 13,3 A atteint 120 V/T, avec pour modèle en mode différentiel SB égal à 9.I (SB exprimé en V/T et I en ampère) et le bruit thermoacoustique Nout égal à 2,8.I$^2$ (Nout en $\mu$V et I en ampères).

La résolution ultime du système 10 est alors calculable et estimée à Nout/SB égal à 500 $\mu$V/120($\mu$V/$\mu$T) soit 4,2 $\mu$T. Si l'on augmente le courant d'un facteur 5 et que l'on réduit la durée d'impulsion d'un facteur 6 à environ 100 ns, alors la résolution ultime se dégrade d'environ un facteur 4 pour atteindre 20 $\mu$T. De même, avec un fil conducteur 50 de diamètre $d_1$ égal à 100 $\mu$m disposé sur un guide fuselé 40 ayant la forme d'un cône conique tronqué dont la surface d'appui 44 a un diamètre $d_2$ égal à 0,2 mm, la zone de sensibilité magnétométrique est au mieux d'environ 0,4 mm par 0,1 mm.

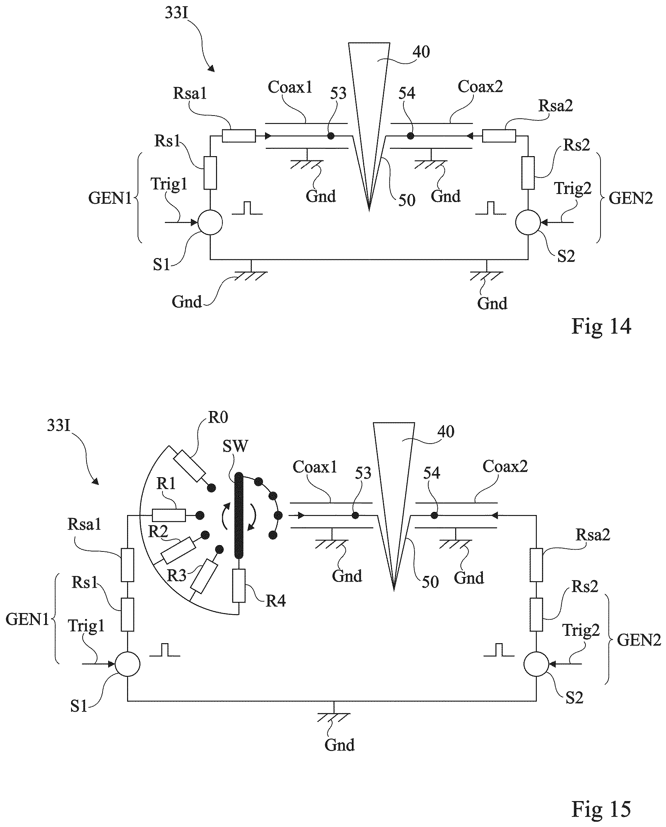

La figure 14 est un schéma électrique d'un mode de réalisation du générateur d'impulsions de courant 33I du système de détection 10 de la figure 7.

Selon un mode de réalisation, le générateur d'impulsions de courant 33I comprend :

- un premier générateur d'impulsions GEN1 comprenant une première source S1 d'impulsions de tension, commandée par un premier signal de commande Trig1, et ayant une première borne reliée, de préférence connectée, à une source d'un potentiel de référence bas Gnd, par exemple la masse, du système de détection 10 et une deuxième borne reliée, de préférence connectée, à une première résistance de sortie Rs1 ;
- une première résistance Rsa1 de limitation de courant dont une première borne est reliée, de préférence connectée, au premier générateur d'impulsions GEN1 ;
- un premier câble coaxial Coax1 dont le blindage est relié, de préférence connectée, à la source du potentiel de référence bas Gnd, dont une première borne est reliée, de préférence connectée, à la première résistance Rsa1 et dont une deuxième borne est reliée, de préférence connectée, à une première extrémité 53 du fil conducteur 50 ;
- un deuxième générateur d'impulsions GEN2 comprenant une deuxième source S2 d'impulsions de tension, commandée par un deuxième signal de commande Trig2, et ayant une première borne reliée, de préférence connectée, à la source du potentiel de référence bas Gnd, du système de détection 10 et une deuxième borne reliée, de préférence connectée, à une deuxième résistance de sortie Rs2 ;
- une deuxième résistance Rsa2 de limitation de courant dont une première borne est reliée, de préférence connectée, au deuxième générateur d'impulsions GEN2 ; et
- un deuxième câble coaxial Coax2 dont le blindage est relié, de préférence connectée, à la source du potentiel de référence bas Gnd, dont une première borne est reliée, de préférence connectée, à la deuxième résistance Rsa2 et dont une deuxième borne est reliée, de préférence connectée, à une deuxième extrémité 54 du fil conducteur 50.

De préférence, le premier générateur d'impulsions GEN1 est identique au deuxième générateur d'impulsions GEN2. En particulier, lorsque les générateurs d'impulsions GEN1 comprennent des transistors MOS, le même type de transistors MOS (par exemple à canal N ou P) est utilisé pour chaque générateur d'impulsions GEN1 et GEN2. Les générateurs GEN1 et GEN2 sont adaptés à fournir des impulsions de tension par exemple égales à 60 V. Les générateurs GEN1 et GEN2 sont déclenchés par les signaux de commande Trig1 et Trig2 qui sont des signaux logiques, de largeur typique égale à 100 ns, d'amplitude égale par exemple à 3,3 V, à temps de commutation court typiquement inférieur à 16 ns et préférentiellement inférieur à 5 ns. La durée des impulsions de tension fournies par les générateurs d'impulsions GEN1 et GEN2 est programmable. Les générateurs GEN1 et GEN2 comprennent les mêmes composants (résistances, transistors) appairés avec des caractéristiques égales à mieux que 0,1 % de façon à produire des impulsions de tension globalement identiques à mieux que 0,2 %. Les générateurs GEN1 et GEN2 peuvent sourcer ou absorber du courant avec une faible impédance de sortie, valant typiquement 0,2 ohm.

Les générateur d'impulsions GEN1 et GEN2 peuvent injecter ou absorber du courant. Lorsque l'on veut faire passer le courant dans le fil conducteur 50 dans un sens, la source S1 est activée et injecte du courant tandis que la sortie de la source S2 est commutée à la masse Gnd et absorbe du courant. Pour inverser le sens du courant, la sortie de la source S1 est cette fois commutée à la masse Gnd, tandis que la source S2 est activée. Les deux sources S1 et S2 peuvent à la fois sourcer ou absorber du courant. Elles fonctionnent de façon synchrone avec leur propre signal de commande Trig1 et Trig2 qui les active durant une durée $\Delta t$.

Les impulsions de courant sont amenées au niveau du fil conducteur 50 par les câbles coaxiaux Coax1 ou Coax2 qui limitent, de façon avantageuse, les couplages inductifs et capacitifs parasites, notamment avec l'amplificateur 35. Les deux résistances Rsa1 et Rsa2 sont identiques. A titre d'exemple, chaque résistance Rsa1 et Rsa2 est comprise entre 0 ohm et 2 ohms, et est de préférence égale à 1 ohm. Les deux résistances Rsa1 et Rsa2 ont pour objectif de limiter le courant maximal devant être absorbé par chacun des générateurs GEN1 et GEN2 lorsqu'il subit l'injection en courant de l'autre générateur, la capacité d'injection étant potentiellement supérieure à la capacité d'absorption, la limitation en courant permet d'éviter de dépasser la capacité d'absorption et de maintenir une bonne similitude entre les impulsions opposées.

Le sens du courant engendré dans le fil conducteur 50 dépend du générateur d'impulsions GEN1 ou GEN2 qui est actif. Les générateurs d'impulsions GEN1 et GEN2 ne sont jamais actifs en même temps.

Selon un mode de réalisation, les générateurs d'impulsions GEN1 et GEN2 sont actifs de façon alternée en produisant chacun une impulsion de courant unique positive de durée $\Delta t$. La durée $\Delta t$ est égale préférentiellement à la demi-période du transducteur électroacoustique 60. L'impulsion de courant émise par l'un des générateurs d'impulsions GEN1 et GEN2 est espacée de l'impulsion de courant émise par l'autre générateur d'impulsions GEN1 et GEN2 par un intervalle 1/PRF (ou PRF désigne la fréquence de répétition des impulsions pour réaliser la mesure différentielle). L'intervalle 1/PRF peut être compris entre 0,1 ms et 100 ms et préférentiellement égal à environ 1 ms.

Selon un autre mode de réalisation, les générateurs d'impulsions GEN1 et GEN2 sont activés de façon à produire une impulsion bipolaire dont la fréquence centrale est préférentiellement celle du transducteur électroacoustique 60. On augmente ainsi la sensibilité de la mesure au prix d'une augmentation du temps d'échantillonnage du champ magnétique $B_z$. Par exemple on pourra déclencher une impulsion bipolaire (ce qui est obtenu par une impulsion du signal de commande Trig1 suivie d'une impulsion du signal de commande Trig2), les deux impulsions étant espacées d'une durée égale à 0,5 $\mu$s, puis, 1 ms plus tard, une seconde impulsion de courant bipolaire opposée (ce qui est obtenu par une impulsion du signal de commande Trig2 suivie d'une impulsion du signal de commande Trig1), servant à implémenter la mesure différentielle.

Selon un autre mode de réalisation, les générateurs d'impulsions GEN1 et GEN2 sont activés de façon à produire des rafales d'impulsions comportant un train d'impulsions de courant, par exemple dans l'ordre (Trig1, Trig2, Trig1, Trig2) suivi d'un train d'impulsions de courant (Trig2, Trig1, Trig2, Trig1) pour la mesure différentielle avec des durées programmables légèrement différentes pour chacune des impulsions du générateur d'impulsions GEN1 (et donc du générateur d'impulsions GEN2), un peu supérieures ou inférieures à la période centrale du transducteur électroacoustique 60 dont la raison sera explicitée ultérieurement dans la mise en oeuvre de la technique de la compression d'impulsions.

Dans les modes de réalisation décrits précédemment, le signal de commande Trig1 ou Trig2 ne déclenche qu'une impulsion rectangulaire positive de largeur et délai programmable. A titre de variante, les signaux de commande Trig1 ou Trig2 peuvent chacun déclencher une rafale d'impulsions positives, chacune des impulsions de la rafale étant définie par son instant de montée par rapport au front montant du signal de commande Trig1 ou Trig2 et sa durée définie en un nombre entier de périodes d'une horloge haute fréquence fonctionnant par exemple à 150 MHz. Ainsi une impulsion de durée égale à 700 ns commençant 6,67 ns après le signal Trig1 ou Trig2 correspondra à un retard de 1 période de l'horloge haute fréquence et une durée de 105 périodes de l'horloge haute fréquence. Tout un train d'impulsions peut être défini de cette manière à partir d'un seul signal de commande Trig1 ou Trig2.

La figure 15 est un schéma électrique d'un autre mode de réalisation du générateur d'impulsions de courant 33I du système de détection 10 de la figure 7.

Le générateur d'impulsions de courant 33I représenté en figure 15 comprend l'ensemble des éléments du générateur d'impulsions de courant 33I représenté en figure 14 et comprend, en outre, des résistances R0, R1, R2, R3 et R4 ayant chacune une première borne reliée, de préférence connectée, à la résistance Rsa1, et comprend un commutateur SW configuré pour connecté la deuxième borne de l'une des résistances R0, R1, R2, R3 et R4 au câble coaxial Coax1. Le commutateur SW peut être un sélecteur mécanique rotatif. Les résistances R0, R1, R2, R3 et R4 ont des valeurs différentes.

Les résistances R0, R1, R2, R3, R4 permettent de sélectionner un calibre de mesure. A titre d'exemple, Rsa1 et Rsa2 sont égales à 0,5 ohm, R0 est égal à 0 ohm, R1 est égale à 3,1 ohms, R2 est égale à 84 ohms, R3 est égale à 856 ohms et R4 est égale à 8570 ohms. La résistance R0 permet d'obtenir les impulsions de courant d'intensités les plus élevées, tandis que les résistances R1, R2, R3 et R4 sélectionnent des plages respectives Plage1 à Plage4 comme indiquées dans le tableau Table 1 suivant avec une impulsion de courant de durée égale à 0,7 $\mu$s.

[Table 1]

| Paramètres | Plage1 | Plage2 | Plage3 | Plage4 |
|---|---|---|---|---|
| Sensibilité (V/T) | 120 | 7 | 0, 7 | 0, 07 |
| Intensité (A) | 13,3 | 0,7 | 0, 07 | 0,007 |
| Bruit (Nout) ($\mu$V) | 500 | 1,37 | 0,014 | 0,00014 |
| Champ équivalent TAN ($\mu$T) | 2100 | 100 | 10 | 1 |
| Champ équivalent Nout ($\mu$T) | 4,2 | 0,2 | 0,02 | 0,002 |
| Détectivité ($\mu$T) | 4,2 | 71 | 714 | 7143 |
| Compensation requise ? | OUI | NON | NON | NON |
| Echantillonage max $B_z$ (Hz) | 1000 | 2000 | 2000 | 2000 |
| Plage de mesure | 0,004 mT - 14 mT | 14 mT - 140 mT | 140 mT - 1,4 T | 1,4 T - 40 T |
| Echelle Pico 5242A | +/- 2 V | +/- 1 V | +/- 1 V | +/- 1 V |
| Résolution Pico 15 bits | 122 $\mu$V | 61 $\mu$V | 61 $\mu$V | 61 $\mu$V |
| Nout rms Moy:1000 | 500 $\mu$V | 500 $\mu$V | 500 $\mu$V | 500 $\mu$V |
| Résolution (% de la plage max) | <0,03 % | <0,05 % | <0,051 % | <0, 024 % |
| $B_z$*I (T.A) | 0, 19 | 0,1 | 0,1 | 0,28 |
| Pressure acoustique à l'extrémité (à Vmax) | <85 dB | <85 dB | <85 dB | <86 dB |

Dans le tableau précédent, le champ équivalent TAN est le champ magnétique correspondant au niveau de bruit thermoacoustique constaté sans compensation. La détectivité limite affichée dans le tableau précédent correspond à une bande passante de 1 Hz et un compromis sur la durée d'échantillonnage du champ qui reste inférieure à la microseconde. Pour des champs statiques, la résolution peut être augmentée via un plus grand nombre de mesures moyennées et donc des périodes d'acquisition plus longues.

De façon avantageuse, l'intensité du courant I diminue avec l'augmentation du champ $B_z$ à mesurer de façon à ce que le produit $B_z$*I soit inférieur à 0,28 A.T et n'engendre pas de problème de sécurité audio ou électrique.

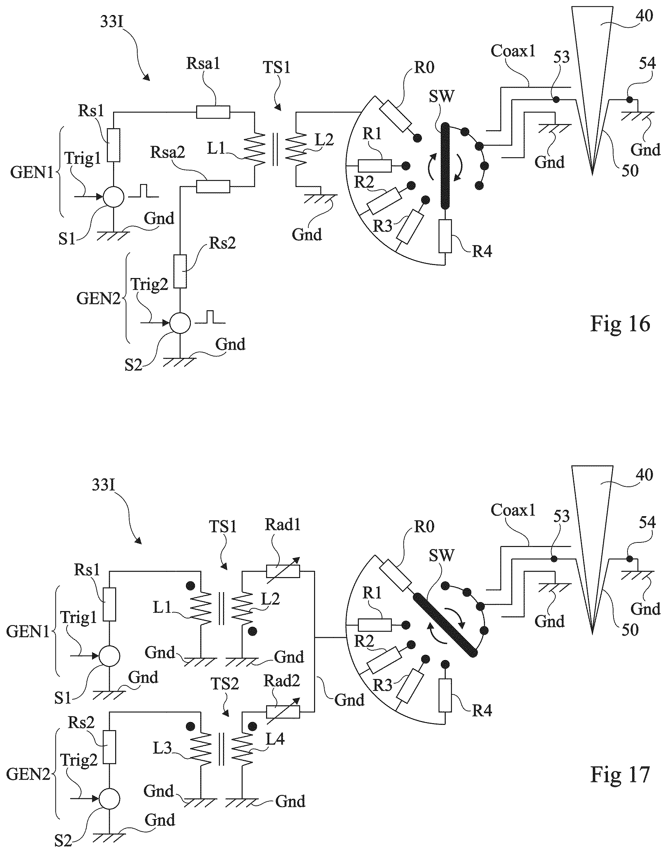

La figure 16 est un schéma électrique d'un autre mode de réalisation du générateur d'impulsions de courant 33I du système de détection 10 de la figure 7.

Le générateur d'impulsions de courant 33I représenté en figure 16 comprend l'ensemble des éléments du générateur d'impulsions de courant 33I représenté en figure 15 à la différence que le câble coaxial Coax2 n'est pas présent, que l'extrémité 54 du fil conducteur 50 est reliée, de préférence connectée, à la source du potentiel de référence bas Gnd, et qu'il comprend en outre un transformateur d'isolement TS1 comprenant un enroulement primaire L1 et un enroulement secondaire L2, la résistance Rsa1 étant reliée, de préférence connectée, à une première borne de l'enroulement primaire L1 et la résistance Rsa2 étant reliée, de préférence connectée, à une deuxième borne de l'enroulement primaire L1, la première borne de chaque résistance R0, R1, R2, R3 et R4 étant reliée, de préférence connectée, à une première borne de l'enroulement secondaire L2, et une deuxième borne de l'enroulement secondaire L2 étant reliée, de préférence connectée, à la source du potentiel de référence bas Gnd. Selon un mode de réalisation, l'inductance de l'enroulement primaire L1 du transformateur d'isolement TS1 est comprise entre 0,5 $\mu$H et 10 $\mu$H, et est de préférence égale à 1 $\mu$H.

La charge inductive constituée par l'enroulement primaire L1 du transformateur d'isolement TS1 est imposée aux générateurs GEN1 et GEN2 d'impulsions positives. Le transformateur TS1 est préférentiellement abaisseur de tension avec un rapport de transformation compris entre 0,25 et 1 de façon à pouvoir augmenter ou maintenir un courant élevé en sortie de l'enroulement secondaire L2. Selon un mode de réalisation, le nombre de spires de l'enroulement primaire L1 est compris entre 5 spires et 20 spires et le nombre de spires de l'enroulement secondaire L2 est compris entre 5 spires et 20 spires. Le transformateur TS1 limite la puissance maximale devant être fournie par les générateurs d'impulsions GEN1 et GEN2 dont les sorties sont connectées à l'enroulement primaire L1. Le sens du courant engendré dans l'enroulement secondaire L2 dépend du générateur d'impulsions actif GEN1 ou GEN2.

Ce mode de réalisation permet donc, de façon avantageuse, de n'utiliser qu'un seul câble coaxial Coax1. Il permet aussi de réaliser des impulsions de courant identiques en valeurs absolues tout en gérant plus facilement le blindage du signal de courant impulsionnel jusqu'au voisinage de l'extrémité du guide fuselé 40.

La figure 17 est un schéma électrique d'un autre mode de réalisation du générateur d'impulsions de courant 33I du système de détection 10 de la figure 7.

Le générateur d'impulsions de courant 33I représenté en figure 17 comprend l'ensemble des éléments du générateur d'impulsions de courant 33I représenté en figure 16 à la différence que les résistances Rsa1 et Rsa2 ne sont pas présentes, que le générateur d'impulsions GEN1 est relié, de préférence connecté à une première borne de l'enroulement primaire L1 du transformateur TS1, qu'une deuxième borne de l'enroulement primaire L1 du transformateur TS1 est reliée, de préférence connectée, à la source du potentiel de référence bas Gnd, qu'il comprend, en outre, un potentiomètre Rad1, que la première borne de chaque résistance R0, R1, R2, R3 et R4 est reliée, de préférence connectée, à une première borne du potentiomètre Rad1, qu'une deuxième borne du potentiomètre Rad1 est reliée, de préférence connectée à la première borne de l'enroulement secondaire L2 du transformateur TS1, qu'une deuxième borne de l'enroulement secondaire L2 du transformateur TS1 est reliée, de préférence connectée, à la source du potentiel de référence bas Gnd, qu'il comprend, en outre, un transformateur d'isolement TS2 comprenant un enroulement primaire L3 et un enroulement secondaire L4, que le générateur d'impulsions GEN2 est relié, de préférence connecté à une première borne de l'enroulement primaire L3 du transformateur TS2, qu'une deuxième borne de l'enroulement primaire L3 du transformateur TS2 est reliée, de préférence connectée, à la source du potentiel de référence bas Gnd, et qu'il comprend, en outre, un potentiomètre Rad2, que la première borne de chaque résistance R0, R1, R2, R3 et R4 est reliée, de préférence connectée, à une première borne du potentiomètre Rad2, qu'une deuxième borne du potentiomètre Rad2 est reliée, de préférence connectée à une première borne de l'enroulement secondaire L4 du transformateur TS2 et qu'une deuxième borne de l'enroulement secondaire L4 du transformateur TS2 est reliée, de préférence connectée, à la source du potentiel de référence bas Gnd.

Ce mode de réalisation permet, de façon avantageuse, de ne pas faire porter sur les générateurs GEN1 et GEN2 la contrainte de la parité à la fois de l'injection et de l'absorption de courant, mais seulement de faire porter sur les générateurs GEN1 et GEN2 la contrainte de la parité de l'injection de courant.

Les deux transformateurs d'isolement TS1 et TS2 produisent des tensions opposées dont les sorties sont connectées. Les deux transformateurs d'isolement TS1 et TS2 sont éventuellement abaisseurs de tension d'un facteur 2 pour diminuer leur impédance de sortie par un facteur 4. En l'absence de charge (la charge correspondant au résistances R0 à R4 et fil conducteur 50) les impédances de sortie des transformateurs TS1 et TS2 étant identiques, la hauteur des impulsions résultantes est divisée par 2 en tensions de sortie. Mais pour le cas des courants les plus forts (concernant R0 et R1), l'impédance de sortie des transformateurs TS1 et TS2 sont grandes devant celle de la charge de sorte que le courant fourni par l'un des transformateurs TS1 ou TS2 débite essentiellement dans la charge et pas dans l'autre transformateur. En cas de légère différence d'efficacité des transformateurs liées à leur fabrication (positions des spires, etc.) engendrant une légère différence de capacité à fournir des courants identiques en valeur absolue, on équilibre les transformateurs TS1 et TS2 via les deux potentiomètres Rad1 et Rad2 qui équilibrent également l'ensemble de la chaîne, y compris une éventuelle légère différence entre les impédances de sortie des générateurs GEN1 et GEN2 jouant sur l'amplitude de courant injecté dans l'enroulement primaire L1 et L3 des transformateurs TS1 et TS2. Les résistances des potentiomètres Rad1 et Rad2 sont comprises entre 0,001 ohm et 2 ohms, et de préférence inférieures à 1 ohm. Chaque inductance des enroulements L1, L2, L3, L4 va par exemple de 0,5 $\mu$H à 2 $\mu$H. Il est préférable de choisir un nombre minimum de spires de façon à maximiser la puissance du transformateur TS1 et TS2 et obtenir une montée en courant rapide par rapport à la période du transducteur électroacoustique 60.

Selon un mode de réalisation, le commutateur SW peut comprendre des interrupteurs reed, également appelés interrupteur à lames souples, commutant via un électroaimant entourant deux lames en vis-à-vis et piloté par un signal de commande. Les temps de commutation des interrupteurs reed sont inférieurs à 1 ms et les résistances de contact inférieures à 0,2 ohm, tandis que les courants de commutation peuvent aisément dépasser 1 A.

Selon un mode de réalisation, la portion 52 du fil conducteur 50 recouvrant la pointe 42 du guide fuselé 40 est amincie localement par rapport au reste du fil conducteur 50 pour réduire l'effet thermoacoustique.

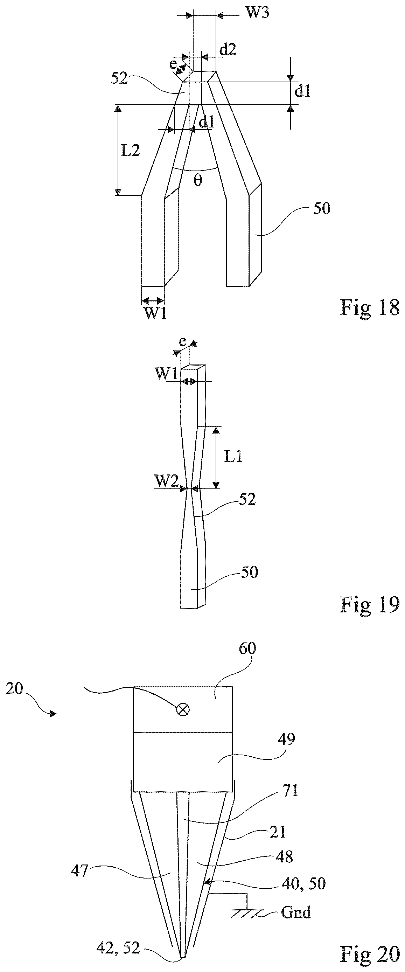

La figure 18 est une vue en perspective, partielle et schématique, d'un mode de réalisation du fil conducteur 50 dont la portion 52, destinée à recouvrir la pointe 42 du guide fuselé 40, non représenté, est amincie et la figure 19 est une vue en perspective, partielle et schématique, du fil conducteur 50 à une étape intermédiaire d'un procédé de fabrication du fil conducteur 50 dont la portion 52 est amincie.

Selon un mode de réalisation, le fil conducteur 50 est formé dans une feuille métallique, dont l'épaisseur est par exemple comprise entre 50 $\mu$m et 300 $\mu$m, préférentiellement égale à 100 $\mu$m, que l'on grave chimiquement par gravure profonde. Le fil conducteur 50 a une section rectangulaire de largeur de base W1 variant par exemple de 200 $\mu$m à 500 $\mu$m. Lorsque le guide fuselé 40 est en un matériau conducteur, la pointe 42 du guide fuselé 40 peut être anodisée avec une couche d'alumine ($Al_2O_3$) sur une pellicule de 5 $\mu$m à 20 $\mu$m d'épaisseur afin d'assurer son isolation électrique.

Selon un mode de réalisation, la configuration de la figure 18 est obtenue directement suite à l'étape de gravure. L'angle $\theta$ est supérieur à l'angle au sommet du cône du guide fuselé 40. L'épaisseur du fil conducteur 50 de section rectangulaire diminue également de W1 à $d_1$ sur une hauteur L2 typiquement égale à 12*(W1-d1). La largeur W3 est égale à d2 + 2*d1 et la largeur d2 est au moins égale au diamètre de la section tronquée du guide fuselé 40. La configuration représentée en figure 18 se prête particulièrement bien au couplage par fusion locale d'un guide fuselé 40 en verre ou insertion dans un guide fuselé 40 en aluminium anodisé tronqué avec fente.

La configuration de la figure 19 est obtenue suite à l'étape de gravure à une étape intermédiaire du procédé de fabrication du fil conducteur 50. La largeur W1 est réduite à une largeur W2 comprise entre 50 $\mu$m et 200 $\mu$m et préférentiellement égale à 100 $\mu$m sur une longueur L1 valant 5 à 15 fois la différence entre W1 et W2, préférentiellement 12 fois, soit égale à 1,2 mm lorsque W1 est égal à 200 $\mu$m et W2 est égal à 100 $\mu$m. Il suffit ensuite de plier en deux le fil conducteur 50 au niveau du col de largeur W2 et de monter le fil conducteur 50 à l'extrémité d'un guide fuselé 40.

La figure 20 est une vue en coupe, partielle et schématique, d'un mode de réalisation de la sonde 20 permettant de réduire l'effet thermoacoustique.

Dans ce mode de réalisation, le guide fuselé 40 est en un matériau conducteur et intègre le fil conducteur 50. Pour cela, le guide fuselé 40 comprend deux demi-guides 47, 48 en un matériau conducteur électriquement, de mêmes dimensions et assemblés par un collage isolant électriquement 71. A titre de variante, le collage isolant électriquement 71 peut ne pas être présent et être remplacé par un interstice d'air. Les deux demi-guides 47, 48 correspondent par exemple à deux demi-cônes. A titre de variante, les deux demi-guides 47, 48 correspondent à deux cônes. Les deux demi-guides 47, 48 sont connectés électriquement à l'extrémité pointue 42 sur une zone extrêmement limitée quasi ponctuelle formant la portion amincie 52 du fil conducteur 50. Chacun des demi-guides 47, 48 devient ainsi une partie du fil conducteur 50 dont la section diminue linéairement pour atteindre une petite section uniquement à l'extrémité des deux demi-guides 47, 48 formant la portion amincie 52 du fil conducteur 50.

Le guide fuselé 40 comprend en outre un tronçon cylindrique 49 en un matériau isolant électriquement, par exemple en verre ou en céramique, fixé à la base des demi-guides 47, 48, de préférence de même diamètre que les demi-demi-guides 47, 48 lorsque ceux-ci correspondent à des demi-cônes. Ceci permet d'isoler spatialement l'impulsion de courant du transducteur ultrasonore 60. La longueur du tronçon cylindrique 49 est comprise entre 1 mm et 20 mm et préférentiellement égale à environ 10 mm. Le tronçon 49 en matériau isolant électriquement présente une impédance acoustique comparable à celle des demi-guides 47, 48 en matériau conducteur électriquement de sorte que le transfert acoustique entre les demi-guides 47, 48 et le tronçon cylindrique 49 se fait relativement efficacement avec un taux de transmission des ondes transverses pouvant dépasser 70 %. La sonde 20 peut comprendre une jupe métallique de blindage 21 entourant les demi-guides 47, 48, à distance des demi-guides 47, 48, et connectée à la source du potentiel de référence bas Gnd. La jupe 21 peut être fixée sur le tronçon cylindrique 49.

Lorsque les demi-guides 47, 49 correspondent à des demi-cônes, le guide fuselé 40 peut être fabriqué par assemblage de deux parallélépipèdes métalliques de même section carrée que l'on colle par le collage isolant électriquement 71, en regard sur l'une de leurs grandes faces et que l'on usine de façon à obtenir les deux demi-cônes 47, 48 de mêmes dimensions. Les deux demi-cônes 47, 48 sont ensuite soudés à l'extrémité pointue 42. Ensuite la base des demi-cônes 47, 48 est couplée au tronçon cylindrique 49.

Ce mode de réalisation permet de réduire considérablement l'expansion thermique et optimise l'efficacité de la génération de l'onde de flexion par la force de Lorentz.

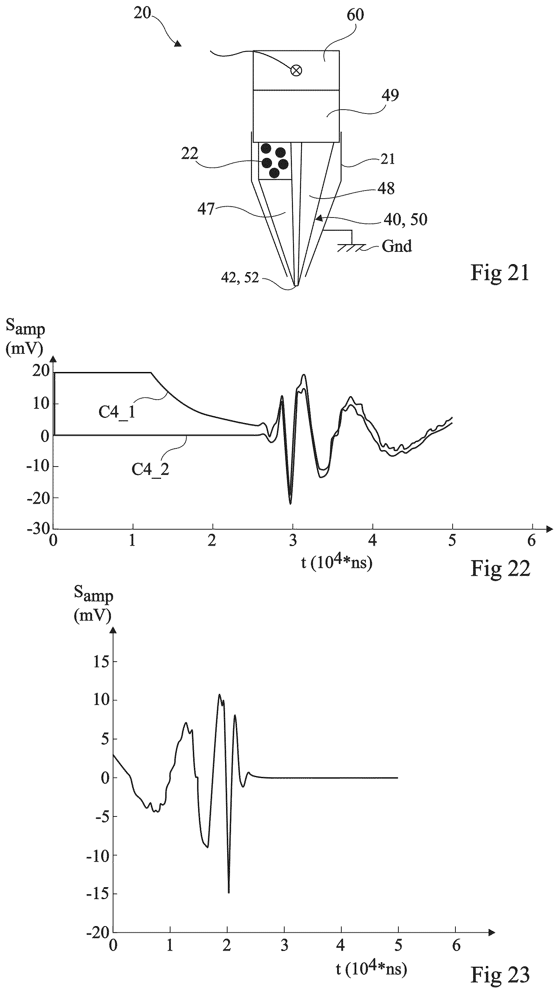

La figure 21 est une vue en coupe, partielle et schématique, d'un autre mode de réalisation de la sonde 20 du système de détection 10 permettant de réduire l'effet thermoacoustique.

La sonde 20 représentée en figure 21 comprend tous les éléments de la sonde 20 représentée en figure 20 à la différence qu'elle comprend en outre un élément amortisseur 22, tel un polymère chargé en poudre métallique, interposé entre la base de l'un des demi-guides 47, 48 et le tronçon 49. Dans ce cas, un seul des demi-guides 47, 48 est raccordé au transducteur ultrasonore 60. Ceci permet d'utiliser qu'un seul des deux demi-guides 47, 48 pour la transmission des ondes acoustiques au transducteur électroacoustique 60, ce qui est avantageux lorsque les deux demi-guides 47, 48 ne sont pas rigoureusement identiques, une petite différence de profil au voisinage de l'extrémité pouvant engendrer une variation de la vitesse de phase responsable d'une différence de phase significative au niveau de la base des demi-guides 47, 48.

La base du demi-guide 47, 48 au contact de l'élément amortisseur 22 agit comme une sortie acoustique destinée à amortir le signal via l'élément amortisseur 22 et réduire le temps de réverbération dans les demi-guides 47, 48 et permettre ainsi une plus grande cadence de mesure PRF (Pulse Repetition Frequency).

Un mode de réalisation d'un procédé d'amélioration de la sensibilité magnétométrique du système de mesure 10 via un traitement du signal par compression d'impulsion qui tient avantageusement compte de la longueur du guide fuselé 40 et de ses propriétés dispersives va maintenant être décrit. Le gain de sensibilité obtenu par la technique de la compression d'impulsion peut être obtenu soit via l'effet dispersif qui se manifeste lors de la propagation dans le guide fuselé 40, soit en créant un train d'impulsions de courant comportant une modulation de fréquence.

Un mode de réalisation dans lequel le gain de sensibilité obtenu par la technique de la compression d'impulsion est obtenu via l'effet dispersif va maintenant être décrit.

En mode de fonctionnement réciproque, lors de la propagation dans le guide fuselé 40 de l'extrémité pointue 42 à la base 41, le mode de flexion engendré à l'extrémité pointue 42 subit un effet dispersif et alors que le champ magnétique est échantillonné à l'extrémité pointue 42 du guide fuselé 40 durant une durée égale à la durée $\Delta t$ de l'impulsion de courant, l'onde résultante au niveau de la base 41 du guide fuselé 40 a changé de forme et son analyse met en évidence une distribution spectrale avec les fréquences les plus élevées situées en tête du paquet d'ondes et les fréquences les plus basses situées en queue du paquet d'ondes.

Cette observation est particulièrement valable si le signal observé aux bornes du transducteur électroacoustique 60 présente une impédance de charge électrique bien plus élevée que l'impédance relative à la capacité intrinsèque du transducteur électroacoustique 60. Par exemple le transducteur électroacoustique 60 peut avoir une capacité intrinsèque de 1,8 nF valant environ 88 ohms à 1 MHz. Si l'impédance d'entrée de l'amplificateur de réception 35 est nettement supérieure à cette valeur, par exemple au moins 5 fois plus grande, soit une valeur comprise entre 470 ohms et 1 kiloohm, alors on peut considérer que le transducteur électroacoustique 60 travaille sous haute impédance de charge et il rend essentiellement compte du déplacement mécanique qui se propage le long du guide fuselé 40, ce qui exhibe relativement bien les fréquences basses. Alors que dans le cas où l'impédance d'entrée de l'amplificateur de réception 35 est inférieure à 88 ohms, on peut considérer que le transducteur électroacoustique 60 fonctionne sous basse impédance de charge et le signal de mesure amplifié $S_{amp}$ est davantage représentatif de la dérivée du déplacement mécanique, donc de la vitesse acoustique, ce qui sélectionne les fréquences élevées.

Pour mettre en oeuvre une technique de compression d'impulsions, il est préférable d'être dans une situation où le paquet d'ondes en sortie du transducteur 60 comprend un signal modulé en fréquence et appliquer à ce signal un filtrage adapté dont la réponse impulsionnelle est en pratique la retournée temporelle de la forme du signal de réception attendue. On met ainsi en oeuvre une fonction d'intercorrélation du signal de sortie avec un filtre adapté ce qui améliore le rapport signal/bruit avec un gain théoriquement égal au produit de la durée de l'impulsion modulée en fréquence par la bande de fréquence impliquée dans la modulation. Pour optimiser la résolution du système de mesure 10, il est préférable de disposer d'un transducteur électroacoustique 60 large bande et d'un train d'impulsions modulé dans la bande de réception du transducteur électroacoustique 60 de durée aussi longue que possible, par exemple d'une durée égale au temps de transit dans le guide fuselé 40. Il est donc préférable d'avoir un guide fuselé 40 relativement long.

Un quatrième essai a été réalisé. Dans le quatrième essai, la sonde 20 utilisée pour le premier essai est utilisé.

La figure 22 représente des chronogrammes C4_1 et C4_2 en fonction du temps du signal de mesure amplifié $S_{amp}$ obtenus pour le quatrième essai. La courbe C4_1 est obtenue pour un signal de mesure amplifié $S_{amp}$ brut avec un amplificateur 35 saturé au début par un couplage parasite lors de l'impulsion de courant en raison d'une absence de blindage et sous haute impédance. La courbe C4_2 est obtenue après la mise en oeuvre d'un procédé de compensation de l'effet thermoacoustique tel que décrit précédemment.

La figure 23 représente une courbe d'évolution en fonction du temps de la réponse impulsionnelle du filtre adapté, c'est-à-dire la retournée temporelle du signal de mesure analogique S en mode compensé (nettoyé des parasites liés au couplage capacitif/inductif au moment de l'impulsion) dans le cas d'un champ magnétique $B_z$ connu de forte intensité pour bénéficier d'un bon rapport signal sur bruit.

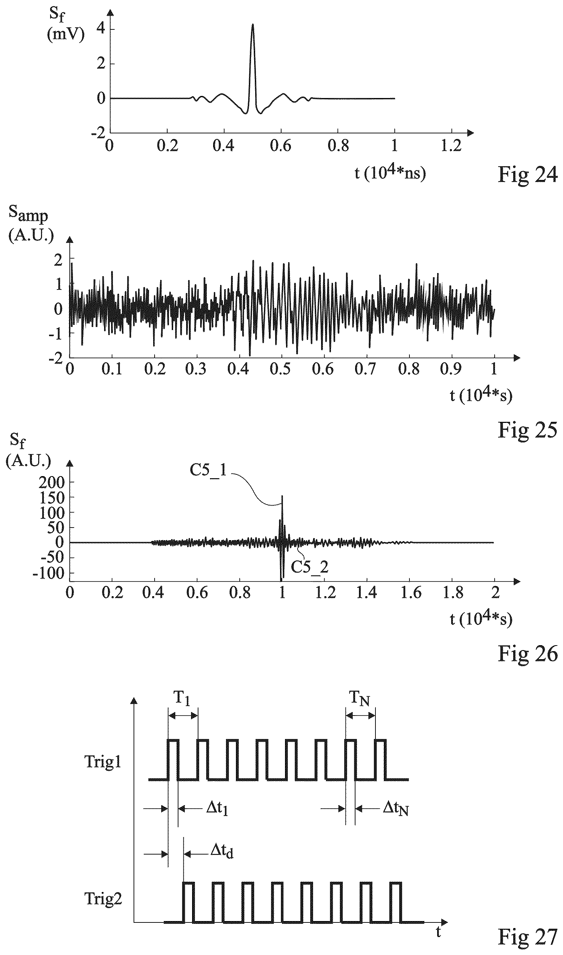

La figure 24 représente un chronogramme du signal de mesure amplifié et filtré $S_f$ obtenu après la convolution du signal de la courbe C4_2 de la figure 22 avec la réponse impulsionnelle du filtre adapté de la figure 23, ce qui produit une fonction d'intercorrélation du signal de sortie avec celle du filtre adapté. La modulation de fréquence liée à l'effet dispersif dans le guide fuselé 40 engendre un effet de compression d'impulsion en sortie de filtrage adapté et une amélioration du rapport signal sur bruit et donc un gain de sensibilité magnétométrique. En outre, on remarque que le signe du maximum de la fonction d'intercorrélation est directement représentatif du pôle magnétique mesuré. Si ce dernier est le même que le pôle du champ de référence nord ou sud, alors le pic est positif, sinon, si le pôle mesuré est opposé, alors le signe est négatif. On a ainsi un moyen simple d'identification du pôle.

Un mode de réalisation dans lequel le gain de sensibilité par compression d'impulsions est obtenu en créant un train d'impulsions de courant comportant une modulation de fréquence va maintenant être décrit.

On applique un train d'impulsions de courant modulées en fréquence entre une fréquence initiale et un fréquence finale et on fait l'acquisition de signaux de mesure S. On applique alors au signal de mesure amplifié $S_{amp}$ un filtrage adapté correspondant à la retournée temporelle de la fonction de modulation de fréquence et également un filtrage adapté au bruit en sortie de l'amplificateur 35 en l'absence de champ magnétique.

Les figures 25 et 26 représentent des chronogrammes, exprimés en unité arbitraire, obtenus par simulation, qui illustrent le gain de sensibilité par compression d'impulsions obtenue par modulation de fréquence d'un train d'impulsions sinusoïdales de courant.

Pour la simulation, les impulsions de courant sont sinusoïdales et dure 25 $\mu$s soit un peu moins que le temps de transit Tr égal à 27 $\mu$s dans un guide fuselé 40 correspondant à un cône de hauteur H égale à 84 mm. Les impulsions de courant sont modulées en fréquence entre une fréquence initiale de 500 kHz et un fréquence finale de 1 MHz, ce qui entre dans la bande passante du transducteur électroacoustique 60.

La figure 25 représente une chronogramme d'un exemple de signal de mesure amplifié $S_{amp}$ obtenu sans filtrage lors de l'application du train d'impulsions de courant sinusoïdales modulé en fréquence décrit précédemment. Pour la simulation, on ajoute un bruit au signal de mesure amplifié $S_{amp}$ pour le rapport signal sur bruit du signal de mesure amplifié $S_{amp}$ soit égal à 2. Le bruit ajouté est un bruit gaussien de moyenne nulle et avec un écart type de valeur 0,5 selon une la loi de distribution normale.

La figure 26 représente des chronogrammes C5_1 et C5_2 du signal de mesure amplifié et filtré $S_f$ (courbe C5_1) et du bruit seul amplifié et filtré (courbe C5_2). Le rapport signal C5_1 sur bruit C5_2 vaut 25. Le gain de rapport signal sur bruit du signal de mesure amplifié et filtré $S_f$ est donc égal à 12,5. Un gain de sensibilité par compression d'impulsions est obtenu par modulation de fréquence d'un train d'impulsions sinusoïdales de courant. Ce gain est égal au produit de la largeur de bande de modulation par la durée de l'impulsion (0,5 MHz*25 $\mu$s).

Selon un mode de réalisation, les impulsions de courant sont rectangulaires, de préférence avec un temps de montée en charge et de décharge en courant du premier ordre.

La figure 27 est un chronogramme des signaux de commande Trig1 et Trig2 modulés en fréquence permettant d'obtenir un train comprenant un nombre N d'impulsions rectangulaires modulées en fréquence, N étant un nombre entier allant par exemple de 2 à 30. Les impulsions des signaux de commande Trig1 et Trig2 ont une durée variant de $\Delta t_1$ à $\Delta t_N$ associée à une période variant de $T_1$ à $T_N$ implémentant une modulation de fréquence $\Delta F$, par exemple entre 300 kHz et 1 MHz, notamment autour de la fréquence centrale F0 du transducteur électroacoustique 60, par exemple égale à 1 MHz. La modulation de fréquence peut ne pas être rigoureusement symétrique autour de la fréquence centrale F0, mais plutôt réalisée en-dessous de la fréquence centrale F0 du transducteur électroacoustique 60 car la focalisation du guide fuselé 40 se dégrade vite vers les fréquences plus élevées et pour un angle au sommet donné du guide fuselé 40. Les trains d'impulsion des signaux de commande Trig1 et Trig2 sont construits à partir d'un signal sinusoïdal x(t) modulé en fréquence en partant de la fréquence la plus élevée $F_N$, égale à $1/T_N$, et finissant à la fréquence la plus basse $F_1$, égale à $1/T_1$, (avec $\Delta F$ égal à la différence entre la fréquence $F_N$ et la fréquence $F_1$) au bout d'une durée totale $T_{burst}$ n'excédant pas le temps de transit Tr dans le guide fuselé 40. La fréquence $F_N$ est par exemple égale à 1 MHz. La fréquence $F_1$ est par exemple égale à 300 kHz. La durée $T_{burst}$ est par exemple égale à 24 $\mu$s pour un guide fuselé 40 conique en aluminium de longueur égale à 85 mm. Le signal sinusoïdal x(t) est donné par la relation suivante :

[Math 10]

$$x(t)=\sin(2\pi(F_N-(0{,}5\cdot\Delta F/T_{burst}*t))*t))$$

avec t variant de 0 à $T_{burst}$ sous la forme de $N_{burst}$ échantillons d'indice i/Fss (où Fss est la fréquence d'échantillonnage du temps, par exemple égale à 16 MHz). On a $N_{burst}$ égal à $T_{burst}*$Fss (arrondi à l'entier le plus proche) et i est un entier qui varie de 1 à $N_{burst}$. La rafale sinusoïdale est ensuite convertie mathématiquement en signaux Trig1 et Trig2 au moyen d'un comparateur de niveau à seuil positif et négatif exprimé en pourcentage du maximum du sinus. Le seuil est choisi typiquement entre 5 % à 60 %, préférentiellement égal à 50 % du maximum du sinus. Lorsque la fonction sinus dépasse le seuil positif, on arrondit à +1 sinon on arrondit à zéro. Le signal résultant présente un rapport cyclique inférieur à 50 %. Il est envoyé dans un générateur de fonction arbitraire en associant une amplitude de sortie à ce signal, par exemple 3,3 V, ce qui fournit le signal Trig1. Lorsque le sinus dépasse négativement le seuil négatif -50 %, on arrondit aussi à +1, sinon on arrondit à zéro. Le signal résultant est envoyé au générateur de fonction arbitraire avec une tension de sortie également ajustée à +3,3 V, ce qui fournit le signal Trig2. On constate ainsi que les signaux Trig1 et Trig2 ne sont pas rigoureusement identiques du fait de la modulation de fréquence. Ensuite, si l'on prend le cas de la figure 17, la mesure en courant alternée consiste à envoyer dans une première phase simultanément les signaux Trig1 et Trig2 au générateur respectifs GEN1 et GEN2, puis dans la phase alternative opposée, on interchange les signaux Trig1 et Trig2 en envoyant le signal Trig1 à l'entrée de synchronisation du générateur GEN2 et le signal Trig2 à l'entrée de synchronisation du générateur GEN1. Les durées des impulsions $\Delta t_1$ à $\Delta t_N$ sont ainsi inférieures ou égales aux demi-périodes respectives $T_1/2$ à $T_N/2$ de façon à ce que les trains d'impulsions des signaux de commande Trig1 et Trig2 aient toujours une intersection temporelle nulle.

Dans les modes de réalisation décrits précédemment, le procédé de compression d'impulsions est mis oeuvre pour un système de mesure 10 fonctionnant dans le mode de fonctionnement réciproque. Toutefois, le procédé de compression d'impulsions peut également être mis oeuvre pour un système de mesure 10 fonctionnant dans le mode de fonctionnement direct.

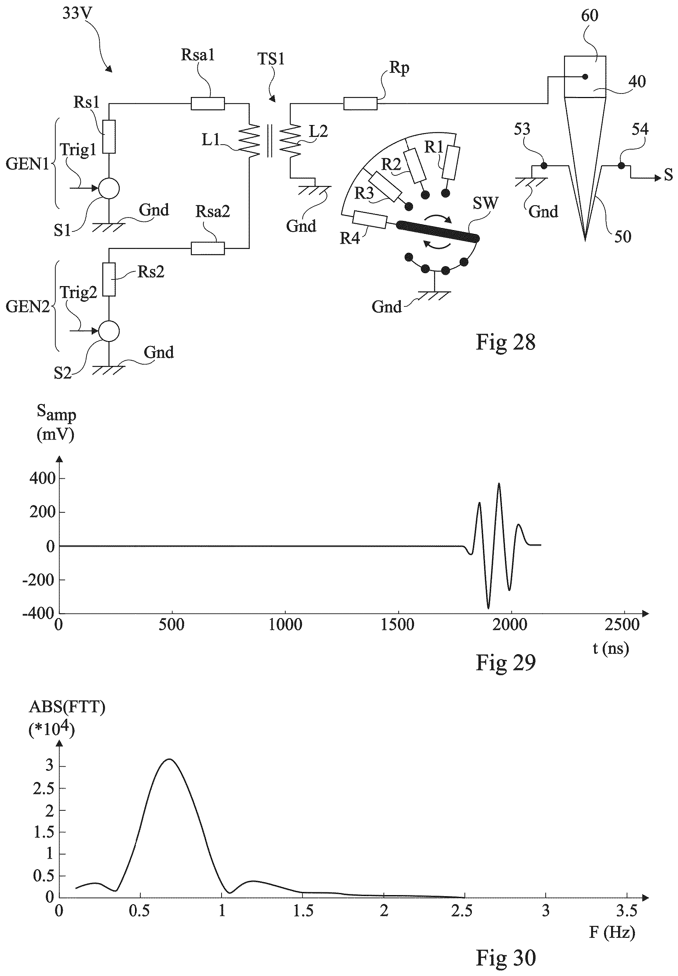

La figure 28 est un schéma électrique d'un mode de réalisation du générateur d'impulsions de tension 33V du système de détection 10 de la figure 8 permettant la mise en oeuvre du procédé de compression d'impulsions en mode de fonctionnement direct.

Le générateur d'impulsions de tension 33V représenté en figure 28 comprend l'ensemble des éléments du générateur d'impulsions de courant 33I représenté en figure 16 à la différence qu'il comprend, en outre, une résistance Rp dont une première borne, est reliée de préférence connectée, à la première borne de l'enroulement secondaire L2 du transformateur TS1, que la première borne de chaque résistance R1, R2, R3, R4 (la résistance R0 n'étant pas présente) est reliée de préférence connectée, à une deuxième borne de la résistance Rp, et est reliée de préférence connectée, à une première borne du transducteur électroacoustique 60 et que Le commutateur SW relie une deuxième borne de l'une des résistances R1, R2, R3, R4 à la source du potentiel de référence bas Gnd. On remarque que dans cette approche, le commutateur mécanique SW peut aisément être remplacé par un commutateur digital à quatre transistors MOS à canal N commandés individuellement au niveau de leur grille par un signal numérique CMOS, les drains des transistors MOS à canal N étant connectés à l'une des deuxièmes bornes des résistances R1, R2, R3, R4 et les quatre sources des transistors MOS étant connectées au même potentiel de référence bas Gnd.

Les signaux de commande Trig1 et Trig2 des générateurs GEN1 et GEN2 peuvent être ceux représentés en figure 27. Les sources S1 et S2 engendrent des impulsions de tension, par exemple d'amplitude égale à 60 V, de durées égales aux impulsions $\Delta t_1$ à $\Delta t_N$ qui sont transformées par le transformateur TS1, par exemple avec un rapport de transformation de 4 à 5. La détection différentielle sur deux acquisitions successives opposées en courant injecté dans l'enroulement primaire L1 du transformateur TS1 peut également être mise en oeuvre de façon à multiplier par deux la sensibilité magnétométrique. Le calibre de mesure est défini via un pont de résistance formé par la résistance Rp et l'une des résistances R1, R2, R3, R4 avec laquelle elle est connectée par le commutateur SW, qui joue sur l'amplitude de la tension appliquée au transducteur électroacoustique 60. L'inductance de l'enroulement primaire L1 vaut par exemple 2 μH. L'inductance de l'enroulement secondaire L2 vaut par exemple 16 fois l'inductance de l'enroulement primaire L1. La résistance Rp vaut par exemple 100 ohms. La résistance R1 vaut par exemple 1 ohm. La résistance R2 vaut par exemple 10 ohms. La résistance R3 vaut par exemple 100 ohms. La résistance R4 vaut par exemple 10 kiloohms.

Dans le mode de fonctionnement direct, il n'y a pas d'effet non linéaire lié à l'effet thermoacoustique. Le signal de mesure S est nul en l'absence de champ magnétique. Toutefois, il est possible de mettre en oeuvre la mesure différentielle sur des acquisitions successives par impulsions de tensions opposées, ce qui a pour effet de doubler la sensibilité. En outre, il est possible de mettre en oeuvre l'excitation par rafales à deux générateurs GEN1 et GEN2 permettant d'engendrer des impulsions bipolaires, ce qui augmente la sensibilité. En outre, il est possible de mettre en oeuvre la compression d'impulsions qui augmente également la sensibilité magnétométrique. La résolution dépend au départ a priori uniquement de l'amplitude de vibration, ce qui peut conduire à créer une vitesse vibratoire très élevée typiquement 30 m/s à l'extrémité de la pointe 42 du guide fuselé 40 au moyen de tensions d'excitation également très élevées. Ceci peut poser un problème de sécurité à la fois électrique, mais également acoustique étant donné les petites dimensions de la pointe qui doit rester à distance des oreilles de l'opérateur. Bien que la vibration soit inaudible et la transmission aérienne très localisée, l'énergie vibratoire peut être intense et potentiellement néfaste.

A titre d'exemple, une sensibilité de 10 mV/T est obtenue avec des impulsions de tension monopolaires de durée égale à 0,5 μs et d'amplitude égale à 300 V. Cette sensibilité peut être doublée avec des impulsions bipolaires, et doublée encore avec des acquisitions successives d'impulsions bipolaires. Il est enfin possible d'améliorer cette sensibilité par un facteur 10 à 15 via le gain de sensibilité apporté par la compression d'impulsions de sorte qu'une détectivité proche du microtesla et une sensibilité supérieure à 1000 V/T peut être atteinte en mode de fonctionnement direct.

La linéarité de la mesure dépend du traitement du signal de mesure S et de la sélection d'une fenêtre de mesure du signal de mesure S. Selon un mode de réalisation, la fenêtre de mesure est limitée à un nombre prédéterminé d'oscillations qui se terminent au moment d'un franchissement de passage à zéro du signal de réception S. Pour ce faire, on annule toute valeur de signal qui précède ou suit cette fenêtre de mesure. Ceci a pour effet de lisser la transformée de Fourier rapide et de permettre de mesurer correctement la raie spectrale d'amplitude maximale si l'on travaille dans l'espace de Fourier. La détermination de la fenêtre de mesure est possible quelle que soit le champ magnétique et le signal remontant due à la force de Lorentz car l'écho interne dans le guide fuselé 40 est indépendant du champ magnétique à mesurer. Il ne dépend que de la distribution de température dans le guide fuselé 40.

Selon un mode de réalisation, pour déterminer la fenêtre de mesure, il est déterminé le temps de transit Tr comme cela a été décrit précédemment en relation avec la figure 12. A titre d'exemple, le transducteur électrostatique 60 est commandé en mode émetteur pour émettre un train d'ondes avec porteuse à la fréquence centrale F0 du transducteur électrostatique 60 ou éventuellement modulé en fréquence autour de la fréquence centrale du transducteur électrostatique 60. Immédiatement après l'émission, le transducteur électroacoustique 60 est commandé en mode récepteur et récupère l'écho interne qui est amplifié par un gain G2 d'un amplificateur de réception. Le gain G2 n'est pas nécessairement très élevé, voire simplement unitaire, car une simple impulsion sinusoïdale d'amplitude 10 V crête suffit à produire un écho d'amplitude 160 mV crête. L'écho a donc, sans amplification, une amplitude d'environ 1 V pour une impulsion de 60 V.

La fenêtre de mesure est obtenue à parti du temps de transit Tr ainsi déterminé. La détermination du temps de transit Tr peut être effectuée avant chaque mesure de champ magnétique. Selon un mode de réalisation, la fenêtre de mesure débute après l'écoulement du temps de transit Tr suite à la première impulsion de tension mise en oeuvre pour la mesure du champ magnétique, éventuellement diminué d'une marge. La fenêtre de mesure se termine après l'écoulement du temps de transit Tr suite à la dernière impulsion de tension mise en oeuvre pour la mesure du champ magnétique, éventuellement augmenté d'une marge.

Dans le mode de fonctionnement direct, en présence d'un champ magnétique à mesurer $B_z$, il apparait une tension aux bornes du fil conducteur 50 que l'on amplifie avec l'amplificateur de réception 35 de gain G1. Le signal de mesure S apparaît après un temps de transit de durée Tr dans le guide fuselé 40 après la première impulsion de tension appliquée au transducteur électroacoustique 60. L'analyse de l'amplitude crête est réalisée directement par un module électronique dédié si l'on exploite l'effet dispersif dans le guide fuselé 40 et une excitation qui est la plus proche possible de la retournée temporelle du signal récupéré aux bornes du fil conducteur 50 dans le cas d'une réponse impulsionnelle (c'est-à-dire une impulsion très courte devant la période 1/F0 du transducteur électroacoustique 60). Si l'on ne tient pas compte de l'effet dispersif du guide fuselé 40 et que l'on engendre par exemple un train d'ondes modulé en fréquence, alors le signal doit être numérisé après amplification G2 avec un nombre d'échantillons limités à la fenêtre de mesure, par exemple 62,5 échantillons/us. Puis le signal numérisé est convolué par un signal de référence qui est le retourné temporel d'un signal obtenu avec un champ magnétique $B_z$ de valeur connue servant de référence. Il suffit ensuite de mesurer la valeur de l'amplitude maximale du signal obtenu que l'on ramène à la valeur de l'amplitude maximale du signal de référence non retourné temporellement convolué avec lui-même (donc l'autocorrélation du signal de référence). Le champ magnétique $B_z$ à déterminer est alors directement la valeur de ce ratio multiplié par le champ magnétique $B_z$ de référence.

Une simulation a été réalisée dans laquelle le système de mesure 10 est utilisé en mode de fonctionnement direct pour la mesure d'un champ magnétique ayant une amplitude égale à 480 mT. Le transducteur électroacoustique 60 est commandé avec une rafale de deux impulsions de tension.

La figure 29 représente un chronogramme du signal de mesure amplifié $S_{amp}$ qui a été mis à zéro avant et après la fenêtre de mesure et la figure 30 représente une courbe de la transformée de fournier ABS(FFT) du signal de mesure amplifié $S_{amp}$ de la figure 29.

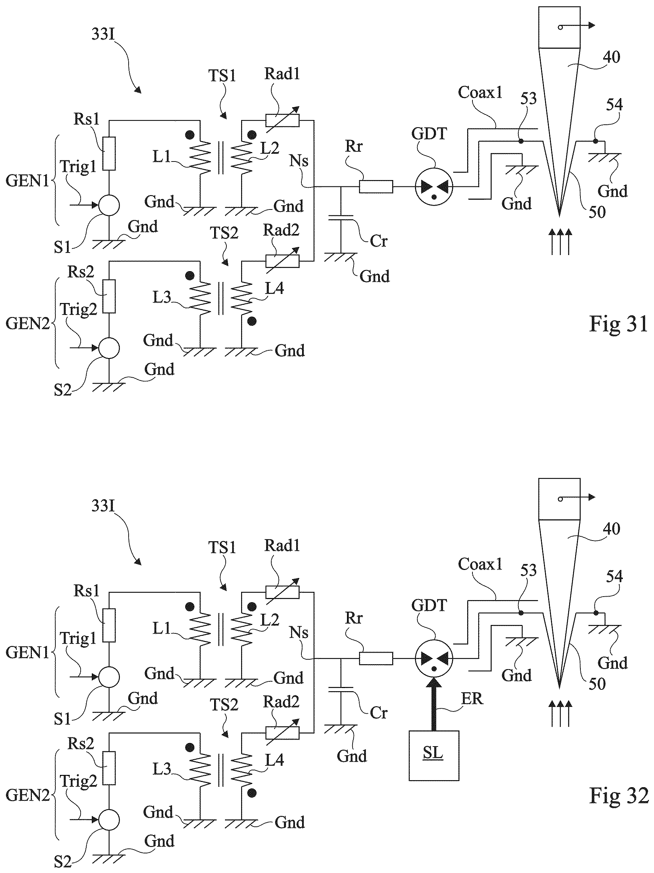

La figure 31 est un schéma électrique d'un autre mode de réalisation du générateur d'impulsions de courant 33I du système de détection 10 de la figure 7 permettant d'échantillonner le champ magnétique $B_z$ avec une période ultracourte, par exemple inférieure à 5 ns.

Le générateur d'impulsions de courant 33I représenté en figure 31 comprend l'ensemble des éléments du générateur d'impulsions de courant 33I représenté en figure 17 à la différence que les résistances R0, R1, R2, R3 et R4 ne sont pas présentes, que l'interrupteur SW est remplacé par à un tube à gaz de décharge GDT dont une première borne est reliée, de préférence connectée, au fil conducteur du câble coaxial Coax1, qu'il comprend en outre un condensateur Cr dont une première électrode est reliée, de préférence connectée, aux résistances Rad1 et Rad2 et dont une deuxième électrode est reliée, de préférence connectée, à la source du potentiel de référence bas Gnd, et qu'il comprend en outre une résistance Rr dont une première borne est reliée, de préférence connectée, aux résistances Rad1 et Rad2 et dont une deuxième électrode est reliée, de préférence connectée, à une deuxième borne du tube à gaz de décharge GDT. On appelle Ns le point milieu entre les résistances Rad1 et Rad2. La tresse du câble coaxial Coax1 est connectée au potentiel de référence bas Gnd de façon à réduire le rayonnement du fil conducteur.

**EP 4 764 576 A1**

Le générateur d'impulsions de courant 33I illustré en figure 31 est adapté à produire une impulsion de courant très courte et de forte intensité pour tenir compte du fait que l'on s'éloigne de la valeur optimale d'une durée d'impulsion égale à la moitié de la période de résonance du transducteur électroacoustique 60 tout en mettant en oeuvre la compensation de l'effet électroacoustique par impulsions de courants en sens opposés.

Les transformateurs TS1 et TS2 sont des transformateurs élévateurs de tension de même rapport de transformation, mais opposés en signe. Les transformateurs TS1 et TS2 sont alimentés par les générateurs d'impulsions GEN1 et GEN2 qui sont des générateurs moyenne tension pouvant aller par exemple jusqu'à 400 V. Ces générateurs moyenne tension GEN1 et GEN2 ont des impédances de sortie faibles Rs1 et Rs2, typiquement inférieures à 4 ohms et alimentent les transformateurs TS1 et TS2. Les résistances d'ajustement Rad1 et Rad2, par exemple inférieures à 1 ohm, permettent d'égaliser en valeur absolue les pentes de charge en tension positive ou négative du condensateur Cr alimenté par les transformateurs TS1 et TS2. La vitesse de croissance de la tension aux bornes du condensateur Cr doit être la plus rapide possible et se situe par exemple entre 5 V/ns et 150 V/ns de sorte que la tension de claquage du tube à gaz de décharge GDT est atteinte avant une demi-période du transducteur électroacoustique 60 soit moins de 500 ns pour un transducteur électroacoustique 60 ayant une résonance de fréquence centrale égale à 1 MHz. En outre, même si la tension de claquage du tube à gaz de décharge GDT fluctue de quelques dizaines de volts d'un claquage à l'autre, la pente est suffisamment élevée pour que la gigue ainsi créée soit inférieure à la nanoseconde.

L'excitation en courant du fil conducteur 50 surmontant la pointe 42 du guide fuselé 40 intervient lors de la décharge du condensateur Cr via le tube à gaz de décharge GDT. Le courant de décharge suit une loi du second ordre définie par le circuit RLC formé par la résistance Rr, l'inductance L2 ou L4, et le condensateur Cr. Pour que l'impulsion de courant de décharge soit monopolaire, on choisit des valeurs pour la résistance Rr et la capacité Cr de façon à ce que le coefficient d'amortissement de ce circuit RLC ait une valeur inférieure à 1 et préférentiellement proche de 0,7. En prenant des valeurs appropriées, on peut ainsi obtenir une impulsion dont la largeur à mi-hauteur est inférieure à 5 ns et par exemple proche de 2,5 ns. Pour cela, on choisit une capacité Cr de préférence inférieure à 150 pF pour que les transformateurs TS1 et TS2 puissent avoir le temps de la charger en un temps court inférieur à 500 ns et de préférence proche de 50 pF à 100 pF, le fil conducteur 50 surmontant la pointe 42 du guide fuselé 40 de courte longueur minimisant son inductance (de préférence inférieure à 10 nH) et une résistance Rr série de décharge suffisamment élevée pour casser la résonance et faire en sorte que le coefficient d'amortissement se rapproche de 0,7 tout en restant suffisamment petite pour que l'amplitude de courant crête atteigne une valeur élevée par exemple 100 A permettant de maximiser la sensibilité magnétométrique. Les transformateurs TS1 et TS2 ont un rapport de transformation de par exemple 7:90 avec 7 spires à l'enroulement primaire L1, L3 et 90 spires à l'enroulement secondaire L2, L4. Une impulsion de 350 V à l'enroulement primaire est ainsi transformée en une impulsion de +4500 V ou -4500 V en sortie de l'enroulement secondaire (en circuit ouvert) selon que le transformateur TS1 ou TS2 est inverseur ou pas. Sachant que les transformateurs TS1 et TS2 sont connectés aux petites résistances d'ajustement Rad1 et Rad2 (inférieures à 1 ohm) et surtout qu'ils constituent une charge l'un pour l'autre avec des impédances de sortie identiques, les impulsions perdent la moitié de leur amplitude au noeud NS, une fois que les transformateurs TS1 et TS2 sont connectés via les résistances d'ajustement Rad1 et Rad2.

Au noeud Ns se produit une impulsion pouvant atteindre une valeur limite proche de +2250 V lorsque c'est le générateur GEN1 qui est actif ou proche de -2250 V lorsque c'est le générateur GEN2 qui est actif. Ces tensions limites sont au moins 10 % supérieures à la tension de claquage du tube à gaz de décharge GDT de sorte que l'on est toujours sûr d'atteindre la tension de claquage du tube à gaz de décharge GDT. Il existe différentes sortes de tube à gaz dans le commerce au format CMS (composant pour montage en surface) avec des tensions de claquage indiquées pour une pente de 1 V/ns pouvant être choisies typiquement entre 600 V et 5000V. A titre de variante, le tube à gaz de décharge GDT peut être réalisé par une simple piste de cuivre coupée, dorée et surmontée d'un capuchon étanche qui fera office de tube à gaz de décharge, l'air faisant office de diélectrique et le capuchon ayant pour rôle de confiner l'ozone créé durant la décharge. On obtient ainsi un dispositif capable de produire des impulsions monopolaires de forte intensité que l'on pourra alterner pour réaliser une mesure différentielle de compensation de l'effet thermoacoustique. La technique de compression d'impulsion perd ici de son intérêt lorsque l'on met en oeuvre un échantillonnage ultracourt sensé accéder à des champs magnétiques haute fréquence à spectre large. Le fort courant de 100 A circulant dans le fil conducteur 50 permet de conserver une sensibilité de 8,6 V/T et une détectivité de 86 $\mu$T par compensation de l'effet thermoacoustique. Ceci suppose que l'on peut contrôler l'instant d'activation du champ magnétique transitoire à mesurer de façon que sa mesure soit synchrone avec l'impulsion de courant et une gigue inférieure à la demi-nanoseconde pour pouvoir mettre en oeuvre une mesure alternée en courants impulsionnels opposés. On suppose également que la vitesse de montée en tension en sortie du transformateur est suffisamment élevée (de préférence supérieure à 100 V/ns) pour que la fluctuation de la tension de claquage du tube à gaz de décharge GDT reste inférieure à la demi-nanoseconde.

La figure 32 est un schéma électrique d'une variante du générateur d'impulsions de courant 33I de la figure 31.

Le générateur d'impulsions de courant 33I représenté en figure 32 comprend l'ensemble des éléments du générateur d'impulsions de courant 33I représenté en figure 31 et comprend, en outre, une source SL configurée pour émettre un rayonnement électromagnétique ER en direction du tube à gaz de décharge GDT, par exemple une source de lumière ou une source de laser UV, permettant de déclencher de façon active le tube à gaz de décharge GDT. Ceci permet de commander avec précision la décharge à l'instant et à la tension souhaités de façon synchrone avec un retard ΔTF par rapport aux signaux de commande Trig1 et Trig2 et avant que la tension n'atteigne le seuil d'auto-déclenchement fluctuant à l'origine de la gigue.

Le rayonnement ER a par exemple une énergie allant de 0,1 mJ à 1 mJ et atteint les électrodes du tube de décharge à gaz ou un matériau cible telle une feuille de zinc disposée au voisinage immédiat des électrodes, de préférence à moins d'un millimètre des électrodes, destiné à recevoir l'impact laser focalisé pour produire par ablation un plasma dans le voisinage immédiat des électrodes ce qui déclenche la décharge de façon synchrone du tube à gaz de décharge GDT. Le laser peut être un laser pulsé ayant de préférence une courte longueur d'onde, par exemple inférieure à 0,4 μm, et est caractérisé par une gigue inférieure à la demi-nanoseconde, des durées d'impulsions typiquement comprises entre 5 ns et 10 ns et une cadence de tir comprise entre 50 Hz et 2000 Hz.

Des exemples d'applications des modes de réalisation du système de mesure de champ magnétique décrits précédemment concernent notamment l'étude de la compatibilité électromagnétique des composants, la caractérisation de composants inductifs ou de sondes inductives de forte intensité, notamment l'étalement des lignes de champ à distance ou de fuites électromagnétiques à travers des fentes ou des ouvertures dans un blindage, ou la caractérisation de la susceptibilité magnétique des matériaux. Un autre exemple d'application est la réalisation d'une tête de lecture pour réaliser des cartographies de champs magnétiques ou lire des données stockées sous forme magnétique par détection d'une polarisation locale binaire ou d'un champ d'amplitude donnée.

Les modes de réalisation du système de mesure de champ magnétique décrits précédemment permettent d'échantillonner un champ magnétique transitoire ou oscillant, de façon synchrone, et très localisé dans l'espace et également très localisé dans le temps via une période d'échantillonnage très courte. En particulier, la résolution spatiale de mesure peut être inférieure à 0,1 mm, la durée d'échantillonnage peut être inférieure à 10 ns, voire à 5 ns. Il est ainsi notamment possible de mesurer des champs magnétiques impulsionnels de durée minimale d'environ 10 ns ou des champs magnétiques variables dont la fréquence maximale est de l'ordre de 100 MHz.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

**1.** Système (10) de mesure d'un champ magnétique ($B_z$) comprenant :

    - un dispositif (20) de détection du champ magnétique ($B_z$) comprenant un guide d'ondes acoustiques fuselé (40) ayant une base (41) et une extrémité effilée (42), un fil conducteur électriquement (50) rigidement couplé à l'extrémité effilée (42) et un transducteur électroacoustique (60) rigidement couplé à la base (41) ; et
    - un dispositif (30) de commande et d'acquisition relié au dispositif (20) de détection du champ magnétique ($B_z$) comprenant un générateur (33I) configuré pour fournir une paire d'impulsions (I+, I-) de courant de sens opposés ou une pluralité d'impulsions de courant modulées en fréquence dans le fil conducteur électriquement (50) et un circuit d'acquisition (32) configuré pour détecter des signaux électriques (S) fournis par le transducteur électroacoustique (60) ou un générateur (33V) configuré pour fournir une paire impulsions de tension de signes opposés ou une pluralité d'impulsions de tension modulées en fréquence commandant le transducteur électroacoustique (60) et un circuit d'acquisition (32) configuré pour détecter des signaux électriques (S) fournis par le fil conducteur électriquement (50).

**2.** Système selon la revendication 1, dans lequel le générateur (33I, 33V) est configuré pour fournir une pluralité de paires d'impulsions (I+, I-) de courant de sens opposés dans le fil conducteur électriquement (50) ou une pluralité de paires d'impulsions de tension de signes opposés commandant le transducteur électroacoustique (60).

**3.** Système selon la revendication 1 ou 2, dans lequel le générateur (33I, 33V) est configuré pour fournir les impulsions ayant des amplitudes maximales en valeur absolue identiques à mieux que 2 % prés.

**4.** Système selon l'une quelconque des revendications 1 à 3, dans lequel la modulation de fréquence de la pluralité d'impulsions de courant ou de tension modulées en fréquence est située dans la bande passante du transducteur électroacoustique (60).

**5.** Système selon l'une quelconque des revendications 1 à 4, dans lequel le circuit d'acquisition (32) est configuré pour déterminer la différence entre les signaux électriques (S) fournis pour la première impulsion (I+) de la paire d'impulsions et la deuxième impulsion (I-) de la paire d'impulsions.

6. Système selon l'une quelconque des revendications 1 à 5, dans lequel le dispositif (30) de commande et d'acquisition est configuré pour déterminer le temps de transit (Tr) des ondes acoustiques dans le guide d'ondes acoustiques fuselé (40) entre la base (41) et l'extrémité effilée (42), le circuit d'acquisition (32) étant configuré pour faire l'acquisition des signaux électriques (S) dans une fenêtre temporelle dont le début par rapport à la première des impulsions dépend du temps de transit (Tr).

7. Système selon l'une quelconque des revendications 1 à 6, dans lequel le fil conducteur électriquement (50) comprend des première et deuxième extrémités (53, 54), dans lequel le transducteur électroacoustique (60) comprend des premières et deuxièmes électrodes, dans lequel le générateur (33I, 33V) comprend des première et deuxième sources de tension (S1, S2), et dans lequel la première source de tension (S1) est reliée à la première extrémité (53) du fil conducteur électriquement (50) ou à la première électrode du transducteur électroacoustique (60).

8. Système selon la revendication 7, dans lequel la deuxième source de tension (S2) est reliée à la deuxième extrémité (54) du fil conducteur électriquement (50) ou à la deuxième électrode du transducteur électroacoustique (60).

9. Système selon la revendication 7, dans lequel le générateur (33I, 33V) comprend, en outre, un premier transformateur (TS1) ayant un premier enroulement primaire (L1) relié à la première source (S1) et un premier enroulement secondaire (L2) relié à la première extrémité (53) du fil conducteur électriquement (50) ou à la première électrode du transducteur électroacoustique (60).

10. Système selon la revendication 9, dans lequel la deuxième source (S2) est reliée au premier enroulement primaire (L1).

11. Système selon la revendication 9, dans lequel le générateur (33I, 33V) comprend, en outre, un deuxième transformateur (TS2) ayant un deuxième enroulement primaire (L3) relié à la deuxième source (S2) et un deuxième enroulement secondaire (L4) relié à la première extrémité (53) du fil conducteur électriquement (50) ou à la première électrode du transducteur électroacoustique (60).

12. Système selon l'une quelconque des revendications 7 à 11, dans lequel le générateur (33I, 33V) comprend, en outre, des résistances (R0, R1, R2, R3, R4) de valeurs différentes et un commutateur (SW) configuré pour mettre en série l'une des résistances (R0, R1, R2, R3, R4) avec la première extrémité (53) du fil conducteur électriquement (50) ou avec la première électrode du transducteur électroacoustique (60).

13. Système selon l'une quelconque des revendications 7 à 11, dans lequel le générateur (33I, 33V) comprend, en outre, un tube à gaz de décharge (GDT) entre la première source (S1) et la première extrémité (53) du fil conducteur électriquement (50) ou la première électrode du transducteur électroacoustique (60) et un condensateur (Cr) ayant une armature reliée à un noeud entre la première source (S1) et le tube à gaz de décharge (GDT).

14. Système selon la revendication 11, comprenant en outre un dispositif d'émission (SL) d'un rayonnement électromagnétique (ER) sur le tube à gaz de décharge (GDT).

15. Système selon l'une quelconque des revendications 1 à 14, dans lequel le fil conducteur électriquement (50) comprend une portion amincie (52) rigidement couplée à l'extrémité effilée (42).

16. Système selon l'une quelconque des revendications 1 à 14, dans lequel le guide d'ondes acoustiques fuselé (40) comprend deux demi-guides d'ondes acoustiques fuselés (47, 48) en un matériau conducteur électriquement et comprenant chacun une extrémité pointue, les deux demi-guides d'ondes acoustiques fuselés (47, 48) étant distants l'un de l'autre sauf pour les deux pointes qui sont fusionnées.

17. Système selon la revendication 16, dans lequel le guide d'ondes acoustiques fuselé (40) comprend en outre un bloc (49) isolant électriquement entre les deux demi-guides d'ondes acoustiques fuselés (47, 48) et le transducteur électroacoustique (60).

Fig 1

Fig 2

Fig 3

Fig 4

Fig 5

Fig 6

Fig 7

Fig 8

Fig 9

Fig 10

Fig 11

Fig 12

Fig 13

30

33I

Rsa1　Coax1　53　54　Coax2　Rsa2

40

Rs1　Rs2

GEN1　Trig1　Gnd　50　Gnd　Trig2　GEN2

S1　S2

Gnd　Gnd

Fig 14

R0

33I　SW

Coax1　53　54　Coax2

R1　40

Rsa1　R2

Gnd　Gnd

Rsa2

Rs1　R3

GEN1　Trig1　R4　50　Rs2　Trig2　GEN2

S1　S2

Gnd

Fig 15

Fig 16

Fig 17

Fig 18

Fig 19

Fig 20

Fig 21

Fig 22

Fig 23

Fig 24

Fig 25

Fig 26

Fig 27

Fig 28

Fig 29

Fig 30

Fig 31

Fig 32

Europäisches
Patentamt

European
Patent Office

Office européen
des brevets

# RAPPORT DE RECHERCHE EUROPEENNE

**Numéro de la demande**

EP 25 21 9103

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2024/353451 A1 (NIKOLOVSKI JEAN-PIERRE [FR]) 24 octobre 2024 (2024-10-24) | 1-3,6,15 | INV. G01R33/028 |
| A | * figures 1-20 *<br>* alinéa [0056] - alinéa [0059] *<br>* alinéa [0064] *<br>* alinéa [0067] - alinéa [0073] *<br>* alinéa [0079] - alinéa [0080] *<br>* alinéa [0088] - alinéa [0092] *<br>* alinéa [0110] - alinéa [0121] *<br>* alinéa [0149] *<br>* alinéa [0156] - alinéa [0157] *<br>----- | 4,5,<br>7-14,16,<br>17 | |
| A | US 5 966 008 A (MAIER REINHARD [DE] ET AL) 12 octobre 1999 (1999-10-12)<br>* figure 1 *<br>* colonne 4 *<br>----- | 1-17 | |
| A | US 5 159 838 A (LYNNWORTH LAWRENCE C [US]) 3 novembre 1992 (1992-11-03)<br>* figure 2 *<br>* colonne 11, ligne 50 - ligne 68 *<br>----- | 1-17 | |
| A | GB 2 540 477 A (NORTHROP GRUMMAN SYSTEMS CORP [US]) 18 janvier 2017 (2017-01-18)<br>* figures 1, 2 *<br>* alinéa [0007] *<br>* alinéa [0030] - alinéa [0033] *<br>----- | 1-17 | DOMAINES TECHNIQUES RECHERCHES (IPC)<br><br>G01R<br>B06B |
| A | VOLOVIK V D ET AL: "ELECTROACOUSTIC MAGNETOMETER",<br>INSTRUMENTS AND EXPERIMENTAL TECHNIQUES, CONSULTANTS BUREAU. NEW YORK, US,<br>vol. 26, no. 4,<br>1 juillet 1983 (1983-07-01), pages 955-956, XP001424990,<br>ISSN: 0020-4412<br>* le document en entier *<br>----- | 1-17 | |

Le présent rapport a été établi pour toutes les revendications

| Lieu de la recherche | Date d'achèvement de la recherche | Examinateur |
|---|---|---|
| Munich | 8 mai 2026 | Philipp, Peter |

## ANNEXE AU RAPPORT DE RECHERCHE EUROPEENNE
## RELATIF A LA DEMANDE DE BREVET EUROPEEN NO.

EP 25 21 9103

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-05-2026

| Document brevet cité au rapport de recherche | Date de publication | Membre(s) de la famille de brevet(s) | Date de publication |
|---|---|---|---|
| US 2024353451 A1 | 24-10-2024 | EP 4450979 A1 | 23-10-2024 |
| | | FR 3148090 A1 | 25-10-2024 |
| | | US 2024353451 A1 | 24-10-2024 |
| US 5966008 A | 12-10-1999 | CA 2218586 A1 | 24-10-1996 |
| | | CN 1181813 A | 13-05-1998 |
| | | DE 19514342 C1 | 22-02-1996 |
| | | EP 0824703 A1 | 25-02-1998 |
| | | JP H11504113 A | 06-04-1999 |
| | | US 5966008 A | 12-10-1999 |
| | | WO 9633417 A1 | 24-10-1996 |
| US 5159838 A | 03-11-1992 | AUCUN | |
| GB 2540477 A | 18-01-2017 | DE 102016111827 A1 | 29-12-2016 |
| | | GB 2540477 A | 18-01-2017 |
| | | JP 6216837 B2 | 18-10-2017 |
| | | JP 2017017699 A | 19-01-2017 |
| | | US 2016380357 A1 | 29-12-2016 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20240230795 A